# EUROPEAN PATENT APPLICATION

(11) **EP 2 103 666 A2**
(43) Date of publication of application: **23.09.2009**
(21) Application number: 09154941.0
(22) Date of filing: 11.03.2009
(51) Int. Cl.: C09K 11/06, H05B 33/14

(54) **Novel organic electroluminescent compounds and organic electroluminescent device using the same**

(30) Priority: 20.03.2008 KR 20080025768
(71) Applicant: Gracel Display Inc., Seoul 133-833 (KR)
(72) Inventor: Lee, Soo Young, 472-120, Gyeonggi-do (KR); Cho, Young Jun, 136-060, Seoul (KR); Kwon, Hyuck Joo, 130-100, Seoul (KR); Kim, Bong Ok, 135-090, Seoul (KR); Kim, Sung Min, 157-886, Seoul (KR); Yoon, Seung Soo, 135-884, Seoul (KR)
(74) Representative: Kent, Venetia Katherine

(57) **Abstract**

The present invention relates to novel organic electroluminescent compounds, and organic electroluminescent devices employing the same as electroluminescent material. Specifically, the organic electroluminescent compounds according to the invention are **characterized in that** they are represented by Chemical Formula (1): 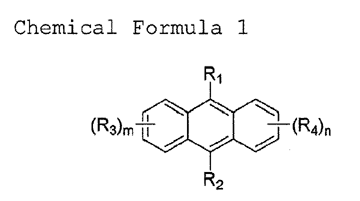 wherein, R₁, R₂, R₃ and R₄ are independently selected from the following structures: 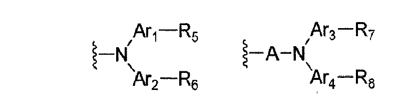 A represents (C6-C60)arylene or (C5-C60)heteroarylene; and
m and n independently represent an integer from 0 to 4, provided that m+n is an integer from 1 to 8.

Since the organic electroluminescent compounds according to the invention have good luminous efficiency and excellent color purity and life property of material, OLED's having very good operation life can be manufactured therefrom.

## Description

### FIELD OF THE INVENTION

The present invention relates to novel organic electroluminescent compounds, and organic electroluminescent devices employing the same as electroluminescent material. Specifically, the organic electroluminescent compounds according to the invention are characterized in that they are represented by Chemical Formula (1): 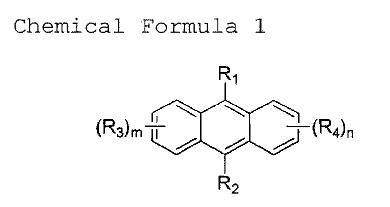 wherein,
R₁, R₂, R₃ and R₄ are independently selected from the following structures: 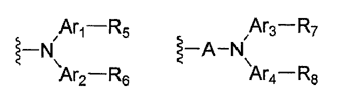
A represents (C6-C60)arylene or (C5-C60)heteroarylene; and
m and n independently represent an integer from 0 to 4, provided that m+n is an integer from 1 to 8.

### BACKGROUND OF THE INVENTION

The most important factor in developing organic electroluminescent devices of high efficiency and long life is development of electroluminescent material of high performance. In view of current development of electroluminescent material, green electroluminescent materials show superior electroluminescent property to red or blue electroluminescent materials. However, conventional green electroluminescent materials still have many problems to achieve manufacturing panels of large size with low power consumption. In view of practical efficiency and life, various kinds of electroluminescent materials for green have been reported up to now. Though they exhibit from 2 to 5 times of electroluminescent property as compared to red or blue electroluminescent materials, development of green electroluminescent material is getting challenged by the improvement of properties of red or blue electroluminescent material. In the meanwhile, enhancement of lifetime of the green material is still insufficient, so that a green electroluminescent material providing long life is seriously required.

As green fluorescent material, a coumarin derivative (Compound D), a quinacridone derivative (Compound E), DPT (Compound F) and the like have been known. Compound D is the structure of C545T that is the most widely used coumarin derivative up to the present. In general, those materials are doped, by using Alq as the host, at a concentration of several % to about several ten wt%, to form an electroluminescent device.

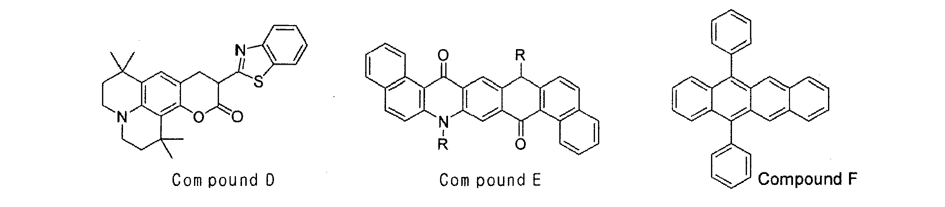

Japanese Patent Laid-Open No. 2001-131541 discloses bis(2,6-diarylamino)-9,10-diphenylanthracene derivatives represented by Compound G shown below, wherein diarylamino groups are directly substituted at 2- and 6-position of anthracene, respectively.

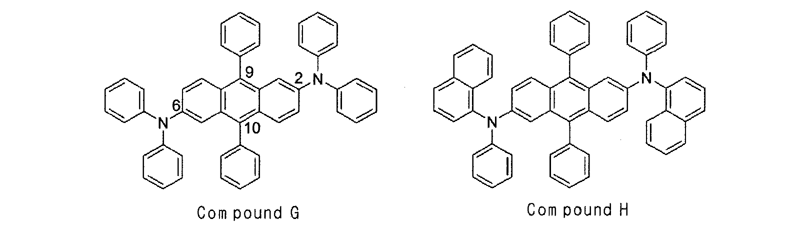

Japanese Patent Laid-Open No. 2003-146951 (which discloses compounds for a hole transport layer) does not mention the compounds wherein diarylamino groups are directly substituted at 2- and 6-position, respectively, but simply describing the compounds having phenyl substituents at 9- and 10-position of anthracene. As considering that Japanese Patent Laid-Open No. 2003-146951 indicated the problem of Compound (H) (wherein diarylamino groups are directly substituted at 2-and 6-position of the anthracene ring, respectively) having poor luminous efficiency, it is found that the invention of Japanese Patent Laid-Open No. 2003-146951 did not recognize the compounds other than those having phenyl substituents at 9- and 10-position of anthracene.

In the meanwhile, Japanese Patent Laid-Open No. 2004-91334 suggested the organic electroluminescent compounds represented by Compound (J), which overcomes poor luminous efficiency of conventional compounds but exhibits low ionization potential and excellent hole transportation, by further substituting the aryl group of the diarylamino group with diarylamino group, even though diarylamino groups are directly substituted on the anthracene group.

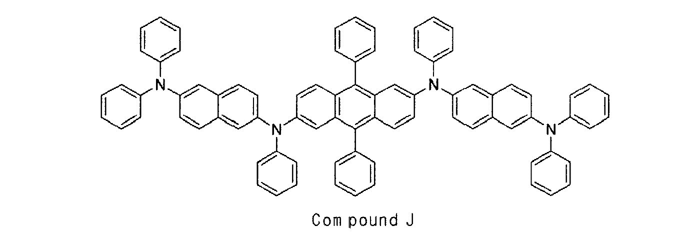

The compounds suggested by Japanese Patent Laid-Open No. 2004-91334 (applied as a hole transport layer), however, show the problem of shortened operation life as a hole transport layer because of too many amine functional groups, even though they showed lowered ionization potential due to many amine functional groups and overcame the problem of increase in hole transporting property.

### SUMMARY OF THE INVENTION

Thus, the inventors have intensively endeavored to overcome the problems described above and to develop novel electroluminescent compounds which can realize an organic electroluminescent device having excellent color purity and luminous efficiency with noticeably improved device life.

The object of the invention is to provide organic electroluminescent compounds having a backbone to provide better luminous efficiency and device life with appropriate color coordinate as compared to conventional dopant material.

Another object of the present invention is to provide an organic electroluminescent device with high efficiency and long life, which employs said organic electroluminescent compounds as electroluminescent material.

The present invention relates to novel organic electroluminescent compounds represented by Chemical Formula (1), and organic electroluminescent devices comprising the same.

Since the organic electroluminescent compounds according to the invention have good luminous efficiency and excellent color purity with life property of material, OLED's having very good operation life can be manufactured therefrom. 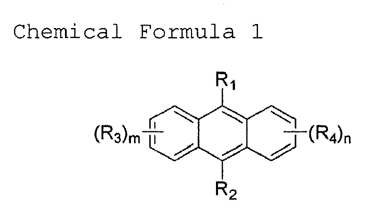 wherein,
R₁, R₂, R₃ and R₄ are independently selected from the following structures: 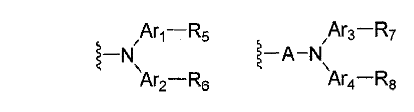
A represents (C6-C60)arylene or (C5-C60)heteroarylene, and the arylene or heteroarylene of A may be further substituted by one or more substituent(s) selected from halogen, deuterium, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl;
Ar₁, Ar₂, Ar₃ and Ar₄ independently represent (C6-C60)arylene or (C4-C60)heteroarylene, which may be further substituted by one or more substituent(s) selected from deuterium, halogen, (C1-C60)alkyl, halo(C1-C60)alkyl, 5- or 6-membered heterocycloalkyl containing one or more heteroatom(s) selected from N, O and S, (C3-C60)cycloalkyl, (C6-C60)aryl, (C4-C60)heteroaryl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl;
R₅, R₆, R₇ and R₈ independently represent hydrogen, deuterium, halogen, (C1-C60)alkyl, halo(C1-C60)alkyl, 5- or 6-membered heterocycloalkyl containing one or more heteroatom(s) selected from N, O and S, (C3-C60)cycloalkyl, (C6-C60)aryl, (C4-C60)heteroaryl, tri(C1-C60)alkylsilyl, di(Cl-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl; or R₅ and R₆, or R₇ and R₈ may be linked via (C3-C60)alkylene or (C3-C60)alkenylene with or without (C1-C10)alkyl susbsituent to form a fused ring, and carbon atom of the alkylene may be further substituted by one or more substituent(s) selected from NR₁₁, SiR₁₂R₁₃, O and S;
R₁₁ through R₁₃ independently represent hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl; or R₁₂ and R₁₃ may be linked via (C3-C60)alkylene or (C3-C60)alkenylene with or without a fused ring to form a spiro ring or a fused ring; and
m and n independently represent an integer from 0 to 4, provided that m+n is an integer from 1 to 8.

### BRIEF DESCRIPTION OF THE DRAWINGS

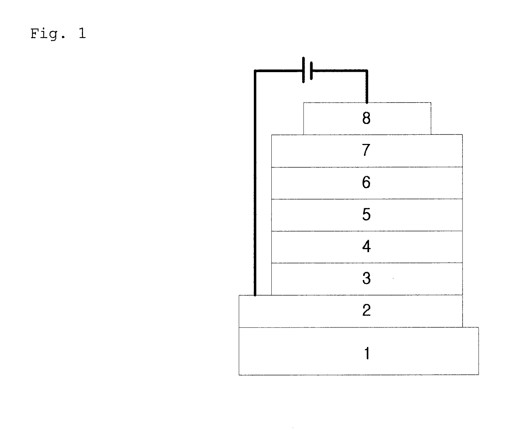

Fig. 1 is a cross-sectional view of an organic light emitting diode (QLED).

### DETAILED DESCRIPTION OF THE INVENTION

Referring now to the Drawings, Fig. 1 illustrates a cross-sectional view of an OLED of the present invention comprising a Glass 1, Transparent electrode 2, Hole injecting layer 3, Hole transport layer 4, Electroluminescent layer 5, Electron transport layer 6, Electron injecting layer 7 and Al cathode 8.

The term "alkyl" includes saturated linear or branched monovalent hydrocarbon radicals consisting of only carbon atoms and hydrogen atoms, or combinations thereof. The term "alkoxy" means -O-alkyl groups, wherein the "alkyl" is defined as above.

The term "aryl" described herein means an organic radical derived from aromatic hydrocarbon via elimination of one hydrogen atom. Each ring suitably comprises a monocyclic or fused ring system containing from 4 to 7, preferably from 5 to 6 cyclic atoms. Further, "aryl" includes the structures wherein more than one aryls are bonded via chemical bond(s). Specific examples include phenyl, naphthyl, biphenyl, anthryl, indenyl, fluorenyl, phenanthryl, triphenylenyl, pyrenyl, perylenyl, chrysenyl, naphthacenyl and fluoranthenyl, but they are not restricted thereto.

The term "heteroaryl" described herein means an aryl group containing from 1 to 4 heteroatom(s) selected from N, O and S for the aromatic cyclic backbone atoms, and carbon atom(s) for remaining aromatic cyclic backbone atoms. The heteroaryl may be a 5- or 6-membered monocyclic heteroaryl or a polycyclic heteroaryl which is fused with one or more benzene ring(s), and may be partially saturated. Further, "heteroaryl" includes the structures wherein more than one heteroaryls are bonded via chemical bond(s). The heteroaryl groups may include divalent aryl groups of which the heteroatoms are oxidized or quarternized to form N-oxides, quaternary salts, or the like. Specific examples include monocyclic heteroaryl groups such as furyl, thiophenyl, pyrrolyl, imidazolyl, pyrazolyl, thiazolyl, thiadiazolyl, isothiazolyl, isoxazolyl, oxazolyl, oxadiazolyl, triazinyl, tetrazinyl, triazolyl, tetrazolyl, furazanyl, pyridyl, pyrazinyl, pyrimidinyl, pyridazinyl; polycyclic heteroaryl groups such as benzofuranyl, benzothiophenyl, isobenzofuranyl, benzimidazolyl, benzothiazolyl, benzisothiazolyl, benzisoxazolyl, benzoxazolyl, isoindolyl, indolyl, indazolyl, benzothiadiazolyl, quinolyl, isoquinolyl, cinnolinyl, quinazolinyl, quinoxalinyl, carbazolyl, phenanthridinyl and benzodioxolyl; and corresponding N-oxides (for example, pyridyl N-oxide, quinolyl N-oxide) and quaternary salts thereof; but they are not restricted thereto. The organic electroluminescent compounds according to the present invention can be selected from those represented by one of Chemical Formulas (2) to (9): 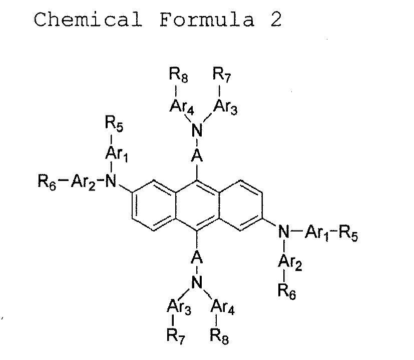 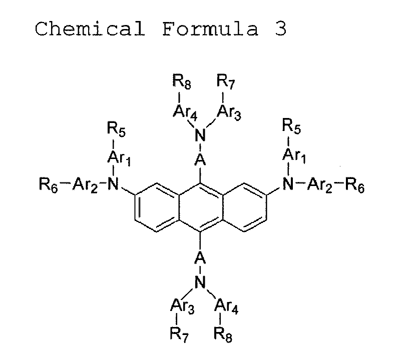 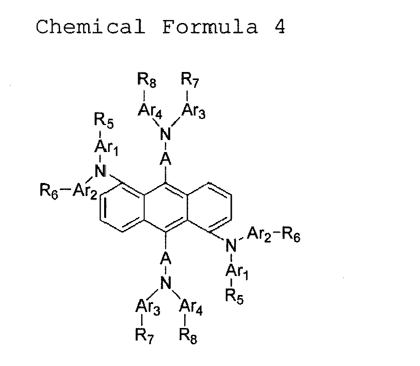 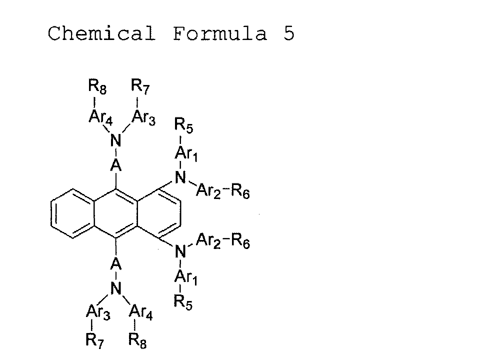 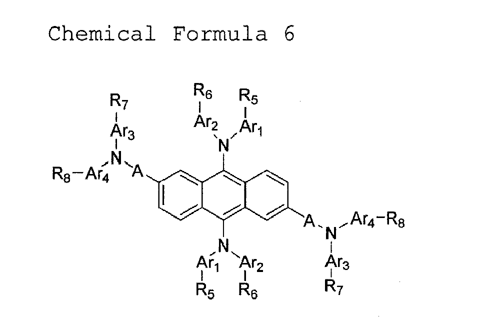 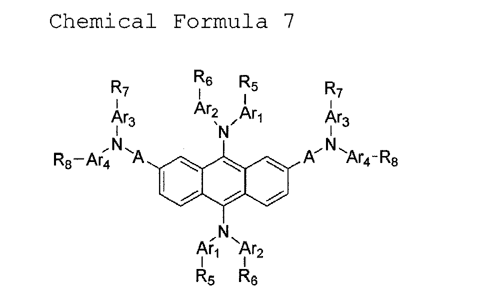 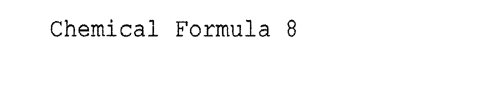 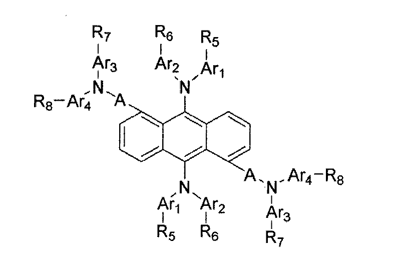 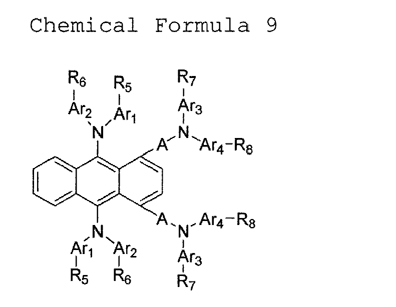 wherein, A, Ar₁, Ar₂, Ar₃, Ar₄, R₅, R₆, R₇ and R₈ are defined as in Chemical Formula (1).

In Chemical Formula (1), 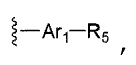 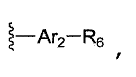 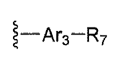 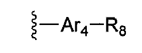 are independently selected from the following structures, but not restricted thereto: 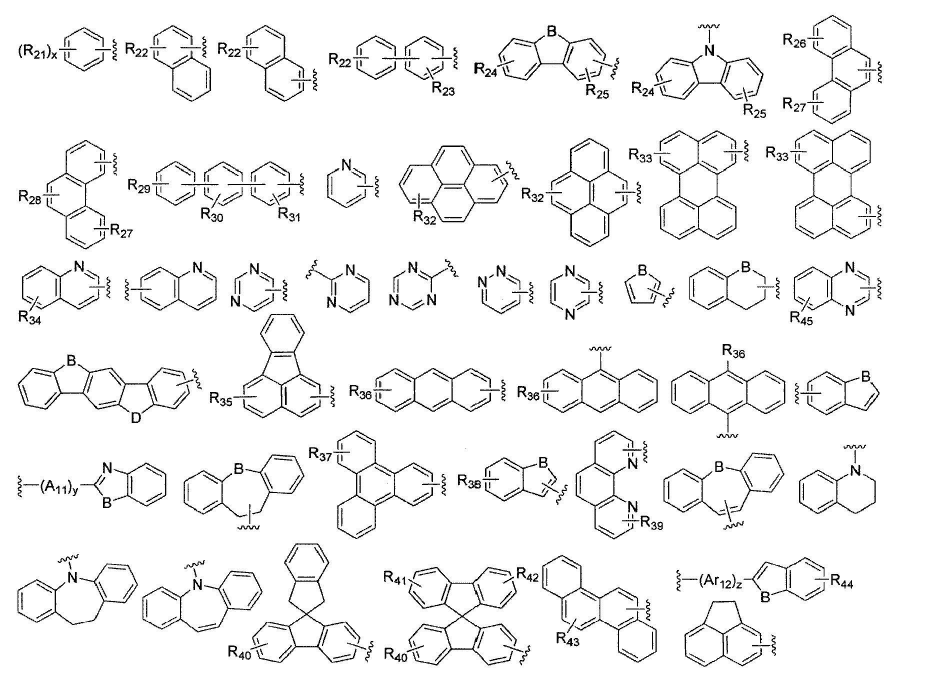 wherein, R₂₁ represents (C1-C60)alkyl, (C1-C30)alkoxy, cyano, halogen, (C6-C60)aryl, (C5-C60)heteroaryl, mono or di(C1-C30)alkylamino, mono or di(C6-C60)arylamino, tri(C1-C30)alkylsilyl, di(C1-C30)alkyl(C6-C30)arylsilyl or tri(C6-C30)arylsilyl;
R₂₂ through R₄₅ independently represent hydrogen, deuterium, (C1-C60)alkyl, (C1-C30)alkoxy, cyano, halogen, (C6-C60)aryl, (C5-C60)heteroaryl, tri(C1-C30)alkylsilyl, di(C1-C30)alkyl(C6-C30)arylsilyl or tri(C6-C30)arylsilyl;
the alkyl, alkoxy, aryl and heteroaryl of R₂₁ through R₄₅ may be further substituted by one or more substituent(s) selected from deuterium, (C1-C60)alkyl, (C1-C30)alkoxy, halogen, cyano, tri(C1-C30)alkylsilyl, di(C1-C30)alkyl(C6-C30)arylsilyl, tri(C6-C30)arylsilyl, (C5-C60)heteroaryl and (C6-C60)aryl;
B and D independently represent CR₄₆R₄₇, NR₄₈, O or S;
R₄₆ through R₄₈ independently represent hydrogen, deuterium, (C1-C60)alkyl, (C1-C30)alkoxy, cyano, halo(C1-C60)alkyl, halogen, (C6-C60)aryl, tri(C1-C30)alkylsilyl, di(C1-C30)alkyl(C6-C30)arylsilyl or tri(C6-C30)arylsilyl;
the alkyl or aryl of R₄₆ through R₄₈ may be further substituted by one or more substituent(s) selected from deuterium, (C1-C60)alkyl, (C1-C30)alkoxy, halogen, cyano, tri(C1-C30)alkylsilyl, di(C1-C30)alkyl(C6-C30)arylsilyl, (C5-C60)heteroaryl and (C6-C60)aryl;
Ar₁₁ and Ar₁₂ independently represent (C6-C60)arylene or (C5-C60)heteroarylene; and the arylene or heteroarylene of Ar₁₁ and Ar₁₂ may be further substituted by one or more substituent(s) selected from deuterium, (C1-C60)alkyl, (C1-C30)alkoxy, halogen, cyano, tri(C1-C30)alkylsilyl, di(C1-C30)alkyl(C6-C30)arylsilyl, tri(C6-C30)arylsilyl, (C5-C60)heteroaryl and (C6-C60)aryl;
x represents an integer from 0 to 5; and
y and z represent an integer from 0 to 2.

The groups, 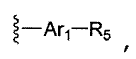 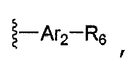 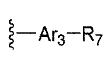 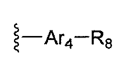 are selected from the following structures, but not restricted thereto.

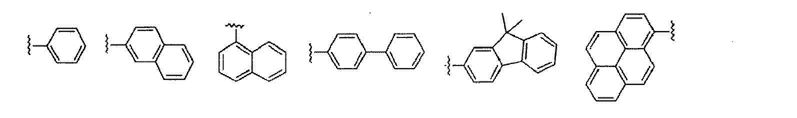

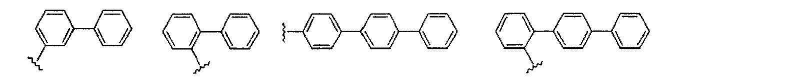

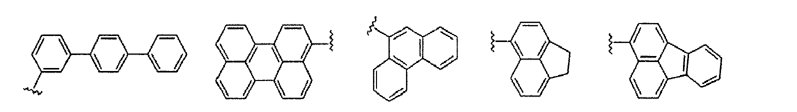

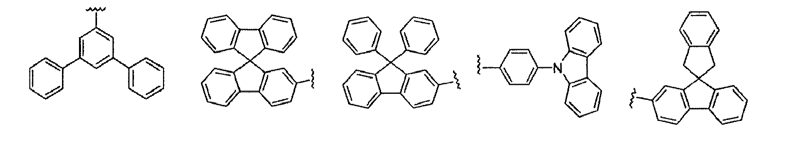

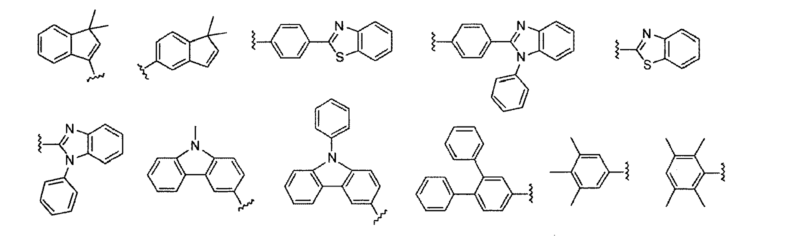

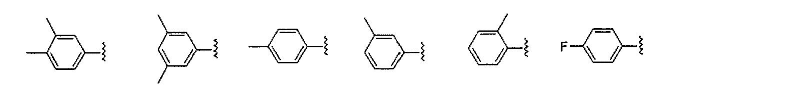

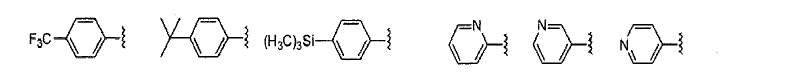

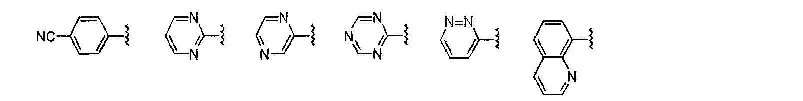

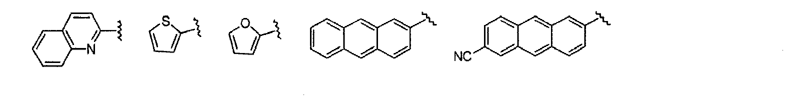

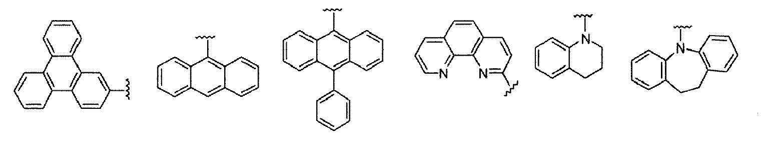

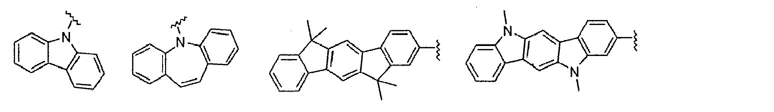

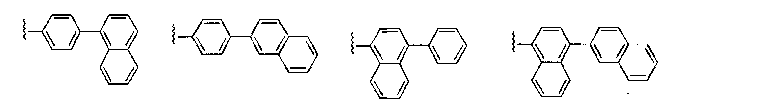

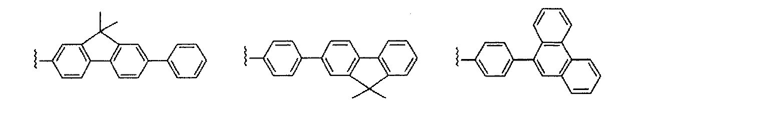

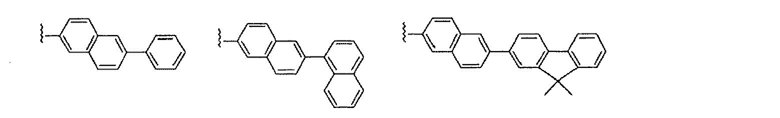

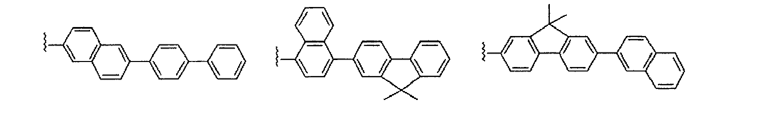

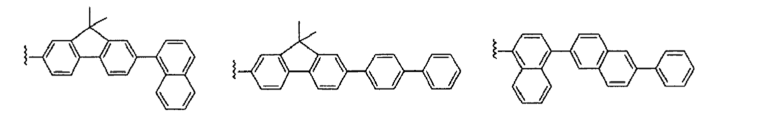

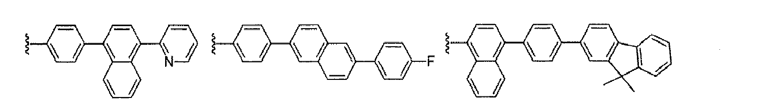

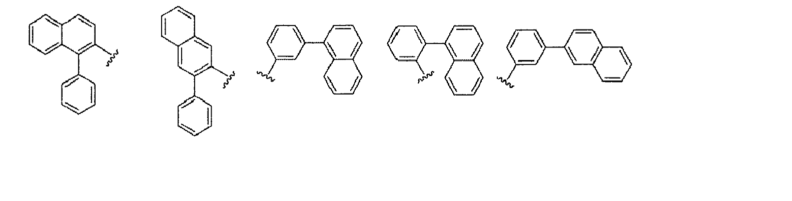

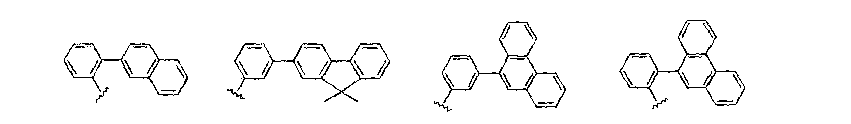

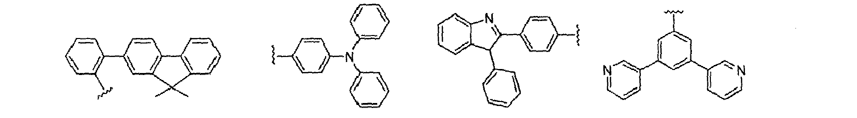

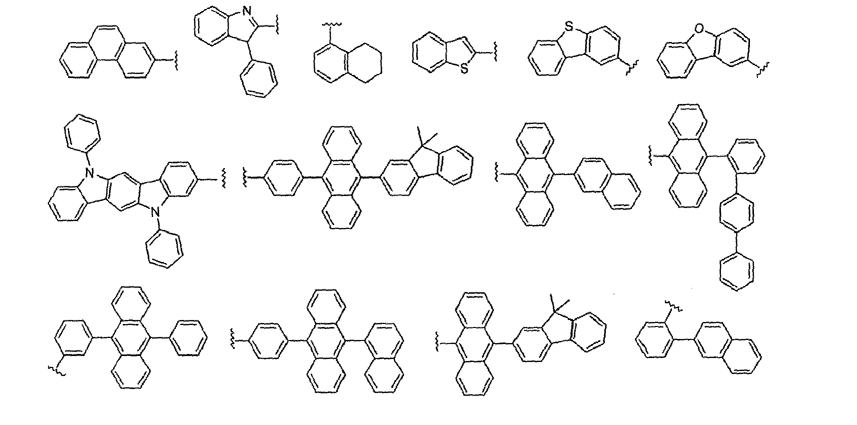

In group 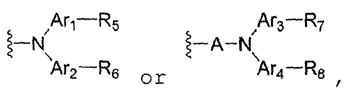 the alicyclic ring or aromatic ring formed from R₅ and R₆ or R₇ and R₈ by independent linkage via alkylene or alkenylene may be exemplified by the following groups, but they are not restricted thereto: 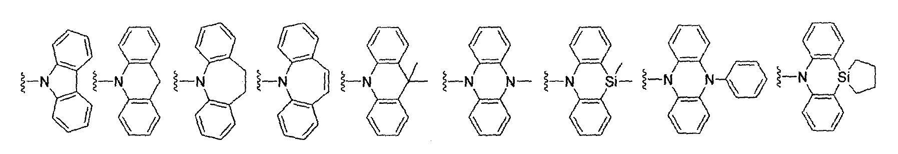 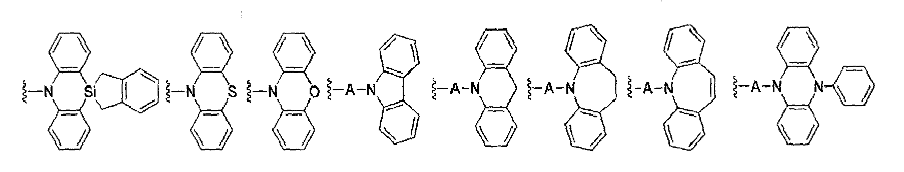 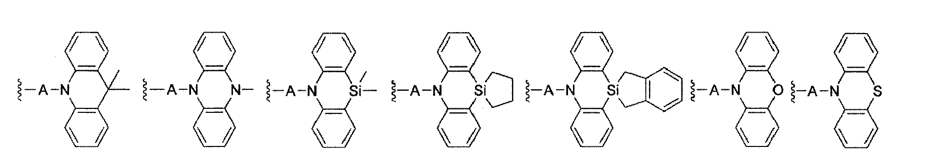 wherein, A is defined as in Chemical Formula (1).

In Chemical Formula (1), A may be selected, without restriction, from the following structures: 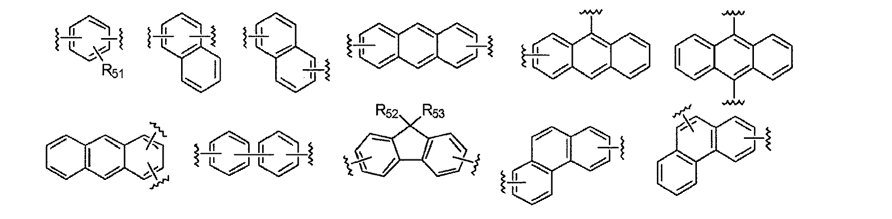 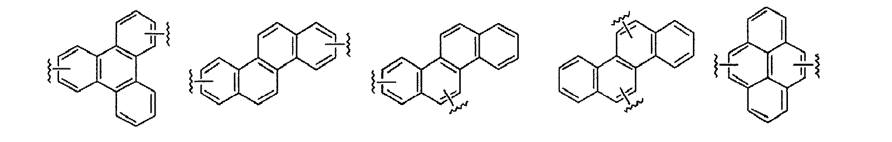 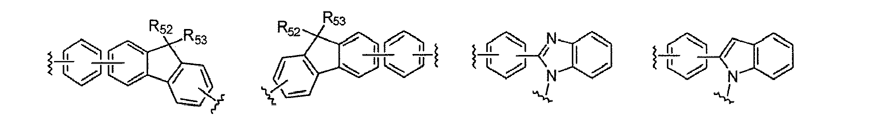 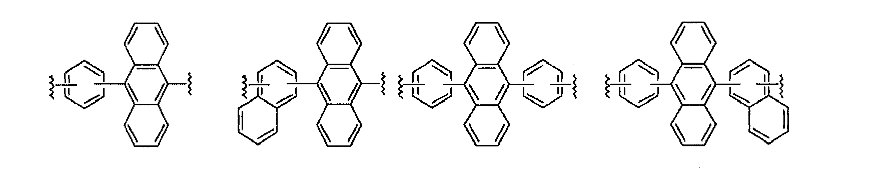 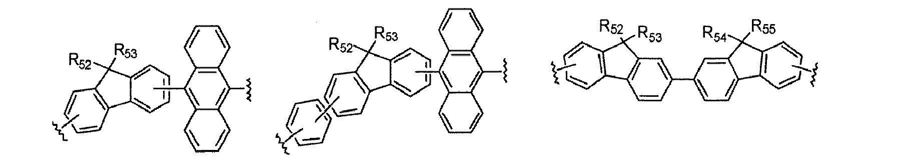 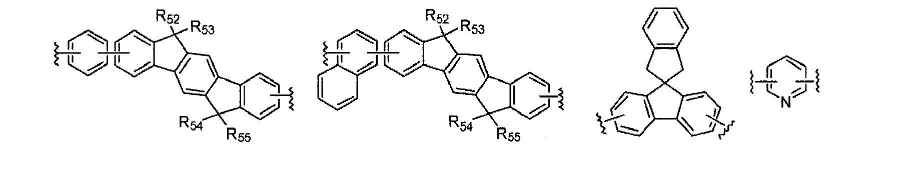 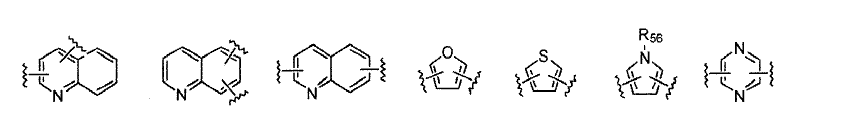 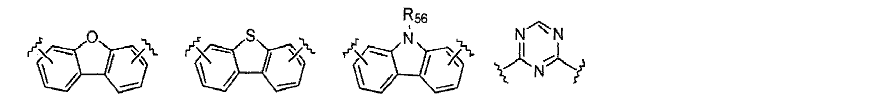 wherein, R₅₁ represents deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl;
R₅₂ through R₅₆ independently represent deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl, or each of R₅₂ through R₅₆ may be linked to an adjacent substituent via (C3-C60)alkylene or (C3-C60)alkenylene with or without a fused ring to form an alicyclic ring, or a monocyclic or polycyclic aromatic ring.

More specifically, the organic electroluminescent compounds according to the present invention can be exemplified, without restriction, by the following compounds:

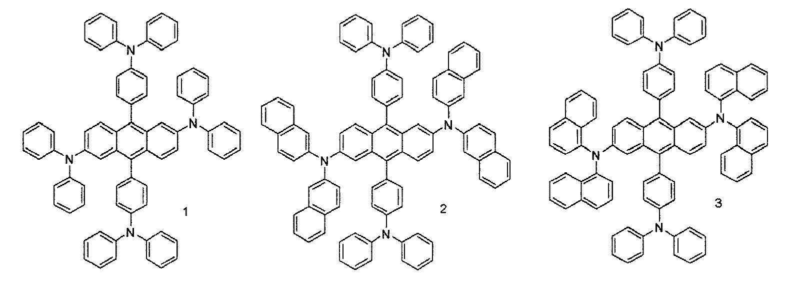

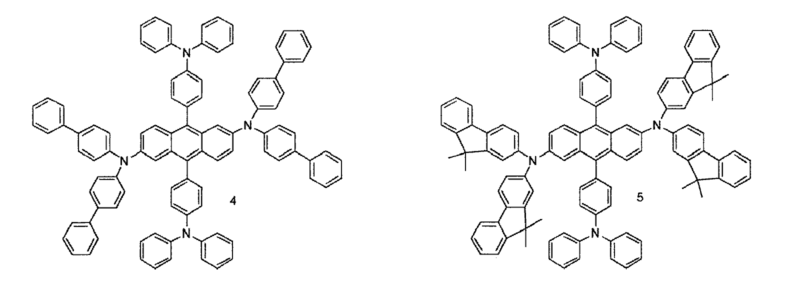

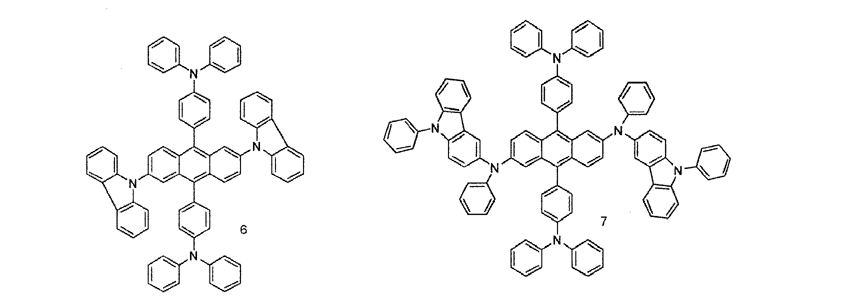

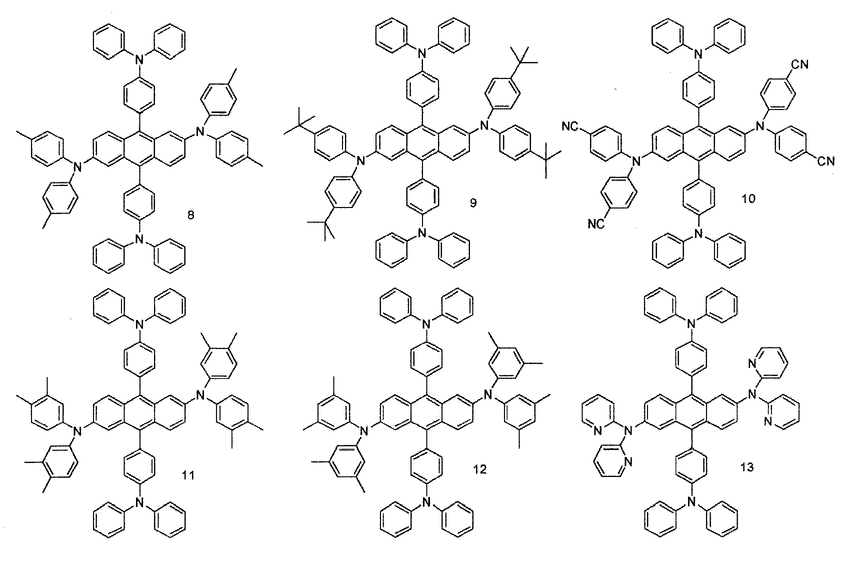

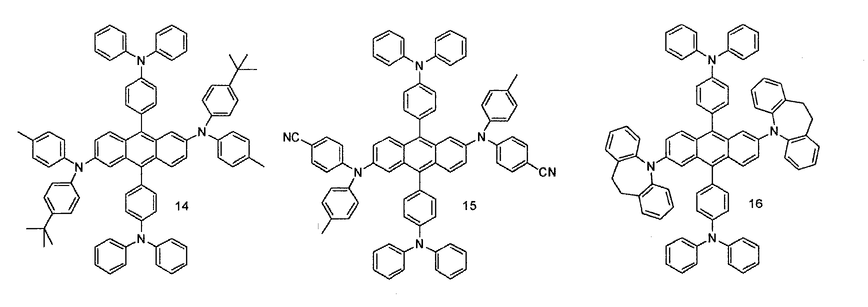

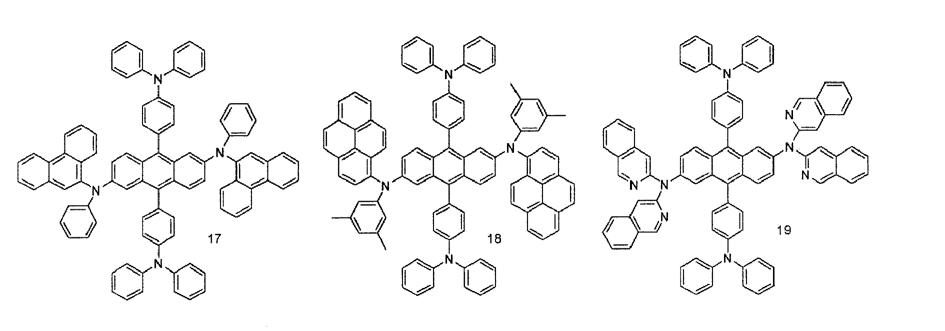

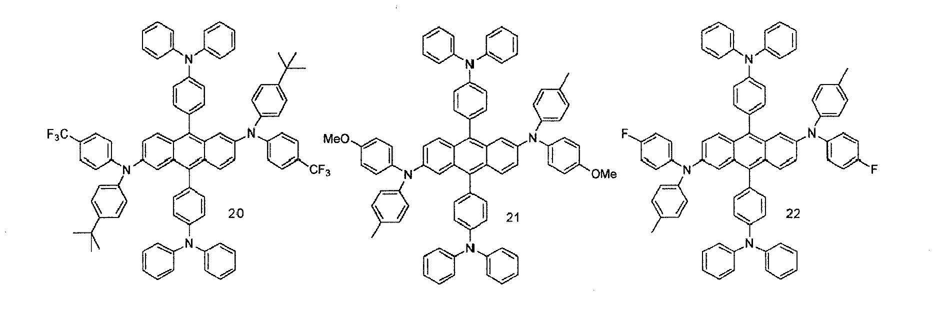

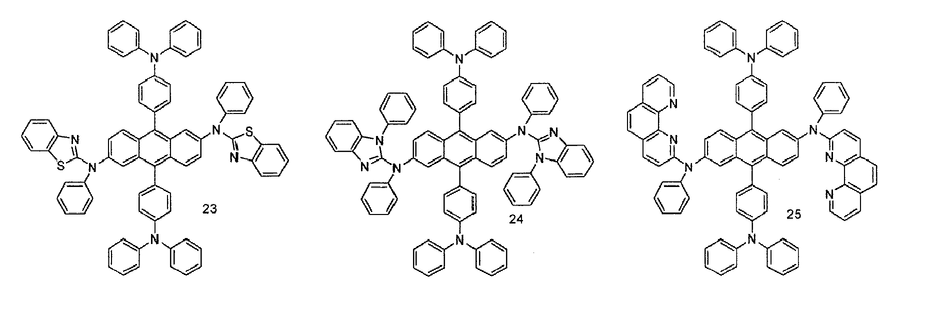

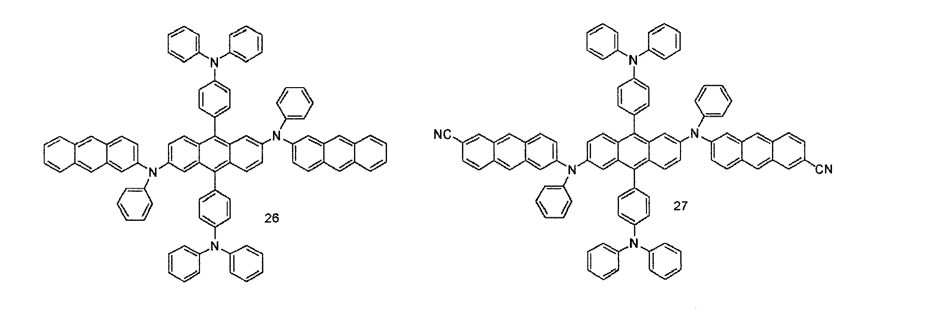

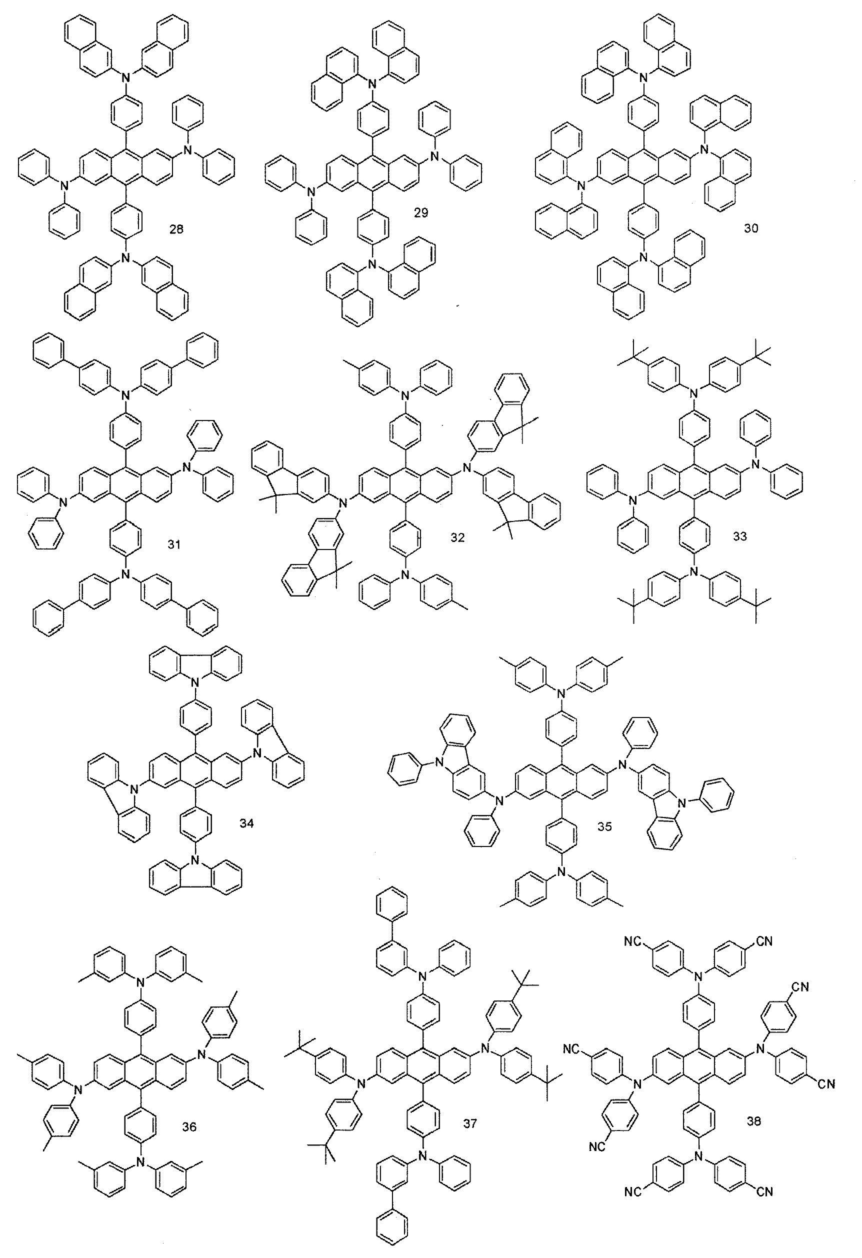

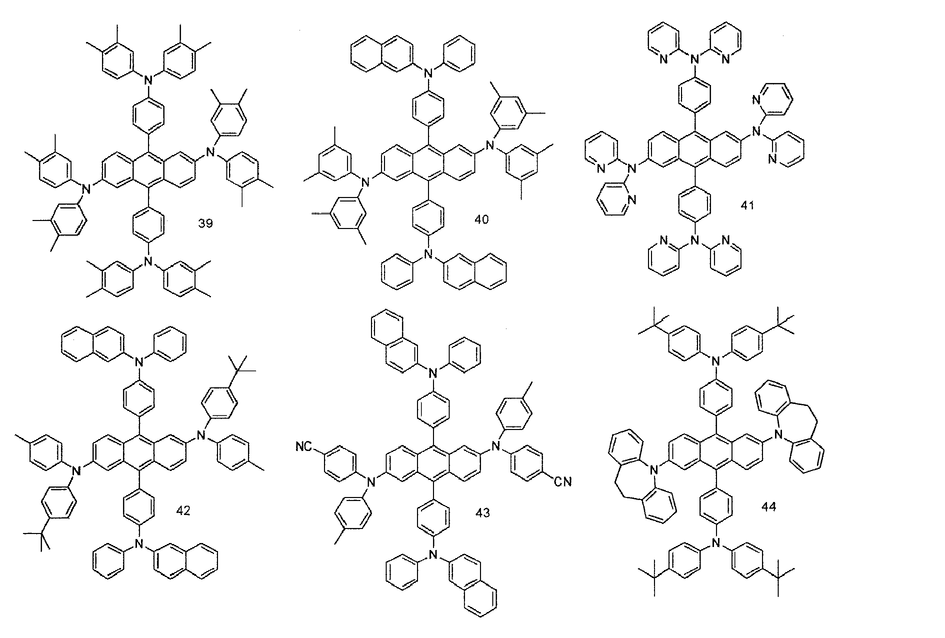

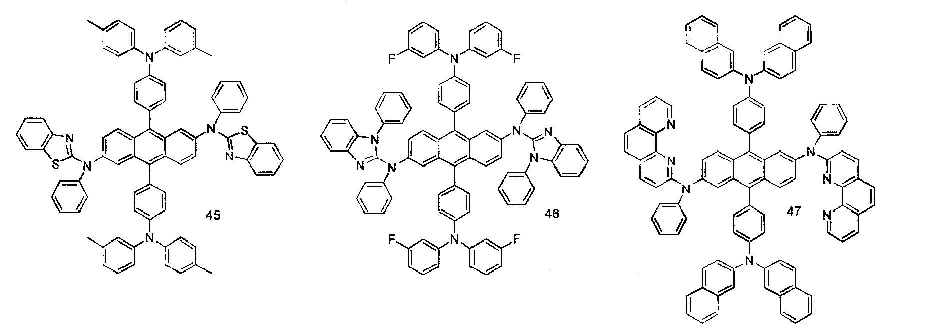

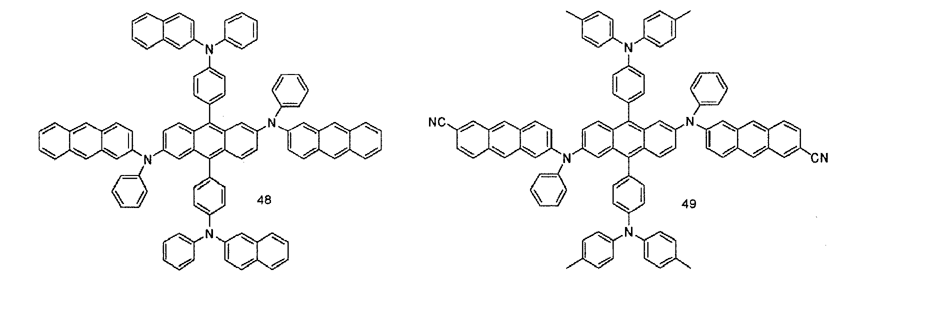

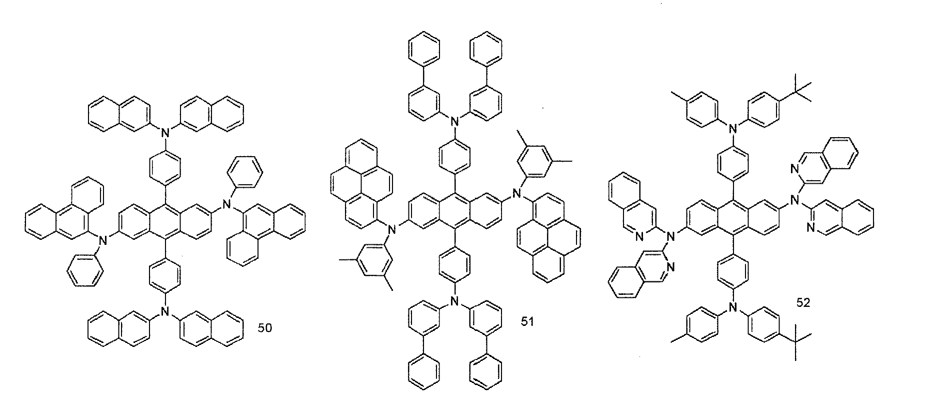

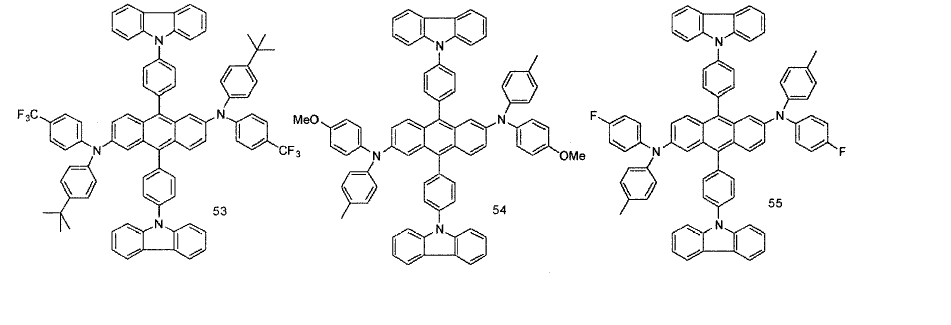

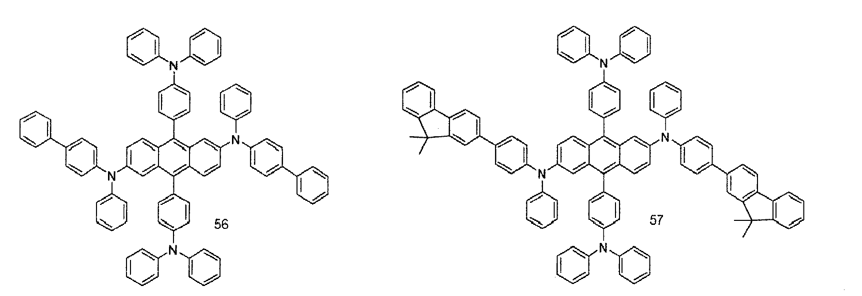

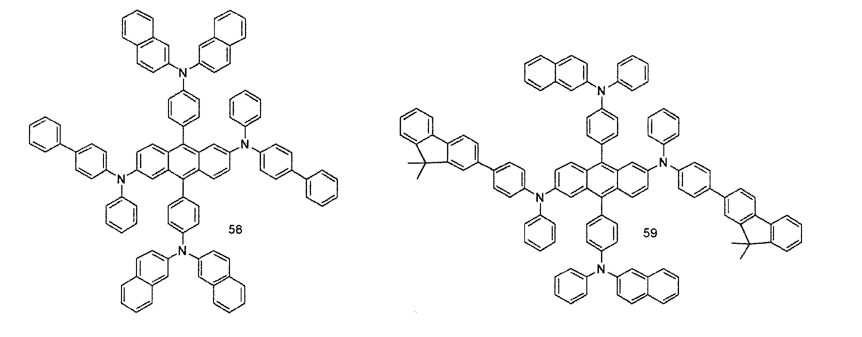

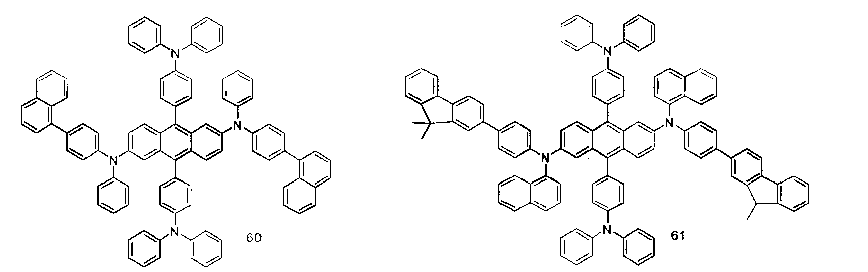

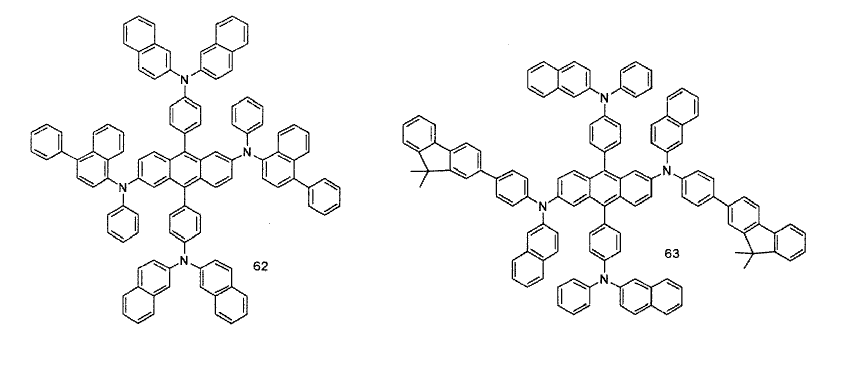

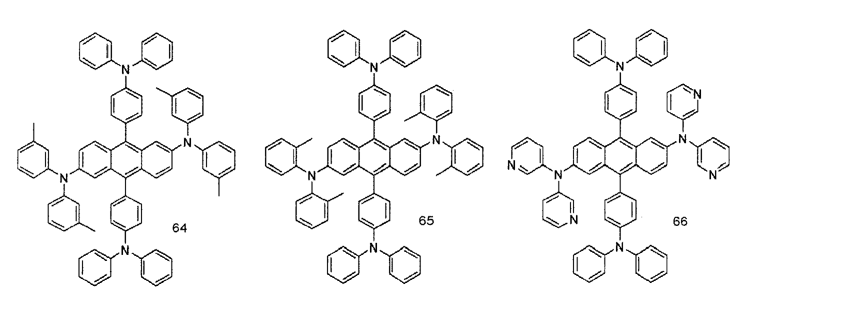

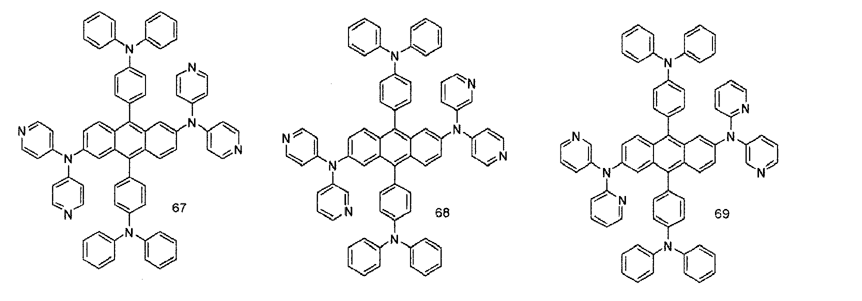

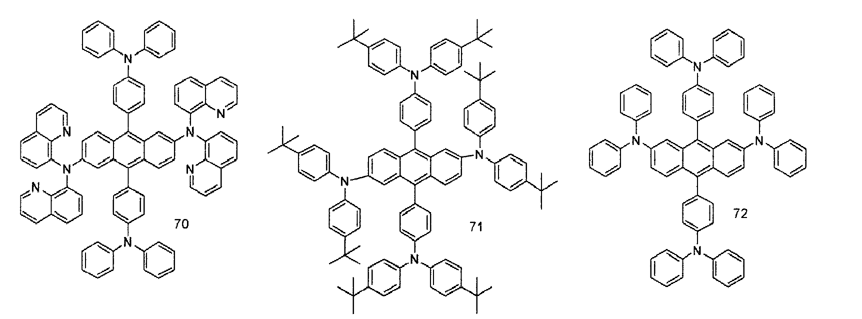

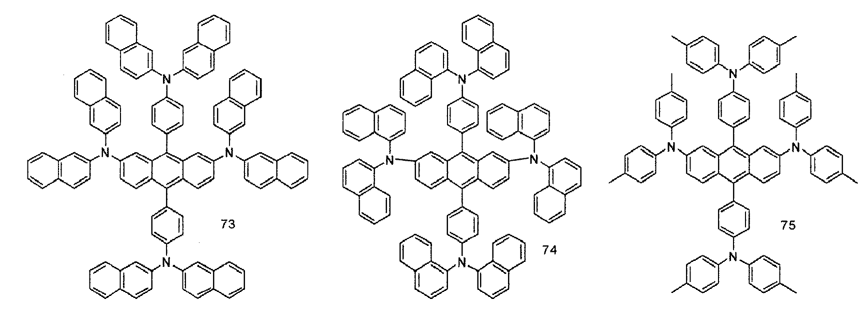

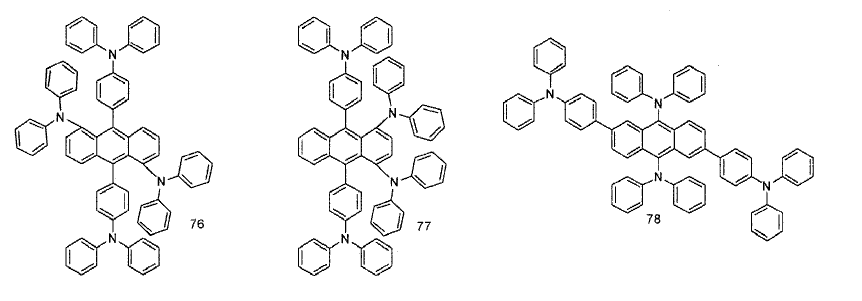

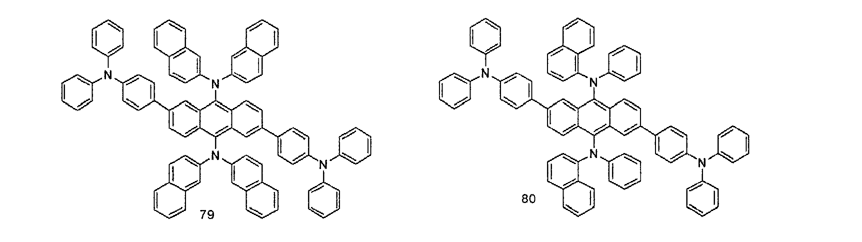

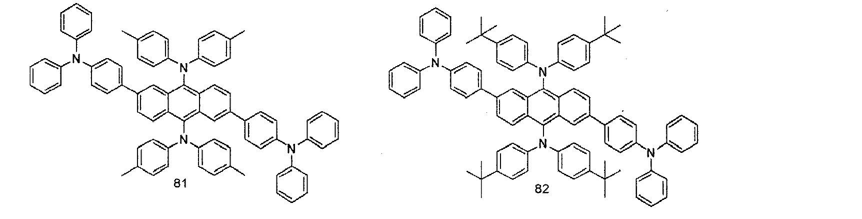

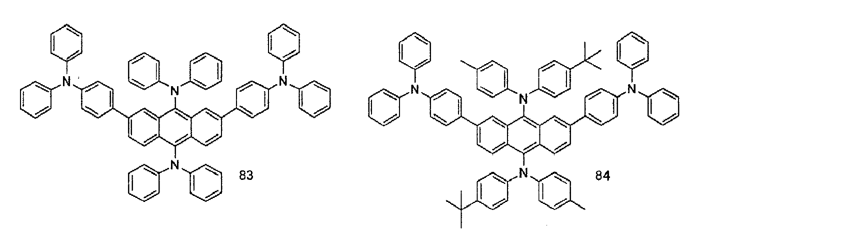

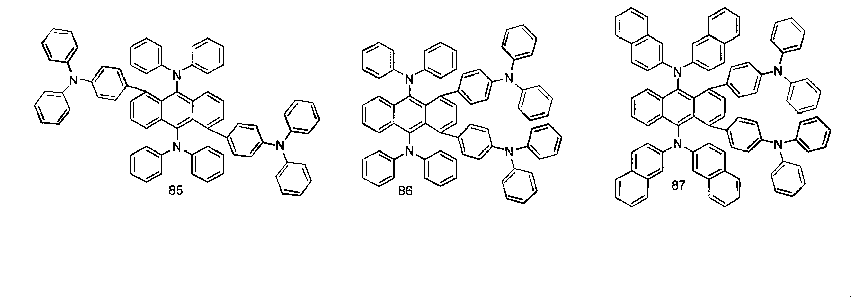

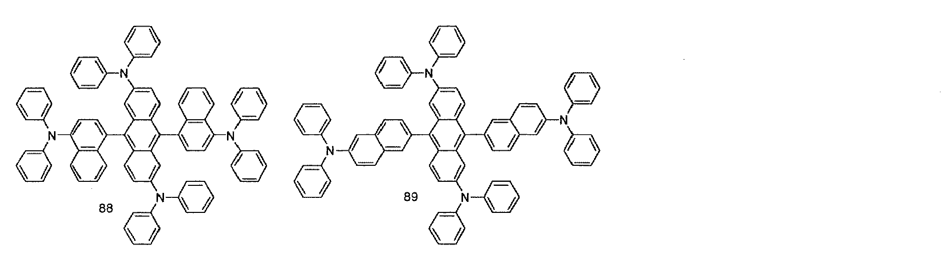

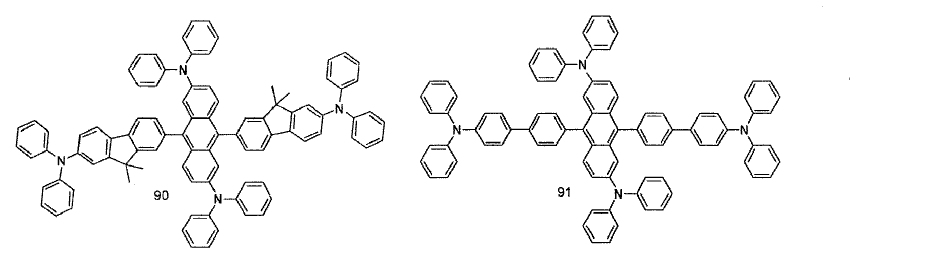

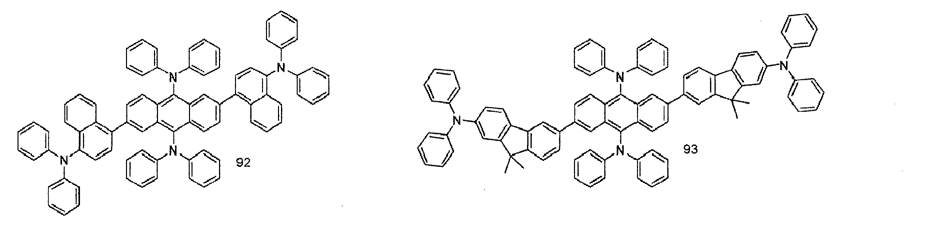

The organic electroluminescent compounds according to the present invention can be prepared according to the procedure illustrated by Reaction Scheme (1): 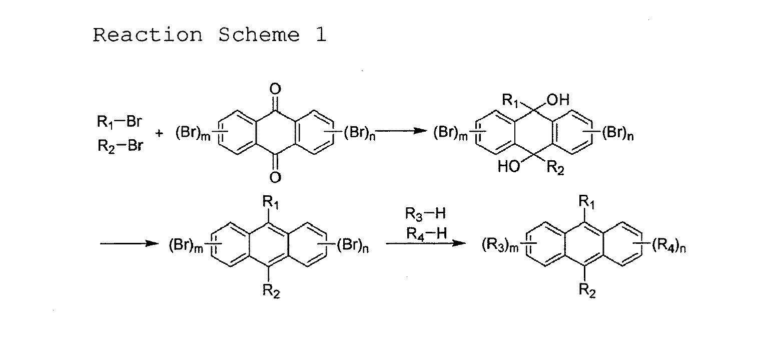 wherein, R₁, R₂, R₃, R₄, m and n are defined as in Chemical Formulas (1).

In addition, the present invention provides organic solar cells, which comprise one or more organic electroluminescent compound(s) represented by Chemical Formula (1).

The present invention also provides an organic electroluminescent device which is comprised of a first electrode; a second electrode; and at least one organic layer(s) interposed between the first electrode and the second electrode; wherein the organic layer comprises one or more organic electroluminescent compound(s) represented by Chemical Formula (1).

The organic electroluminescent device according to the present invention is characterized in that the organic layer comprises an electroluminescent layer, and the electroluminescent layer comprises one or more compound(s) represented by Chemical Formula (1) as electroluminescent dopant, and one or more host(s).

The host applied to the electroluminescent device according to the invention is not particularly restricted, but preferably selected from the compounds represented Chemical Formula (10) or (11):

Chemical Formula 10 (Ar₂₁)_{b}-L₁- (Ar₂₂)_{c}

Chemical Formula 11 (Ar₂₃)_{d}-L₂- (Ar₂₄) ₑ

wherein,
L₁ represents (C6-C60)arylene or (C4-C60)heteroarylene;
L₂ represents anthracenylene;
Ar₂₁ through Ar₂₄ are independently selected from hydrogen, deuterium, (C1-C60)alkyl, (C1-C60)alkoxy, halogen, (C4-C60)heteroaryl, (C5-C60)cycloalkyl and (C6-C60)aryl; and the cycloalkyl, aryl or heteroaryl of Ar₂₁ through Ar₂₄ may be further substituted by one or more substituent(s) selected from a group consisting of (C6-C60)aryl or (C4-C60)heteroaryl with or without one or more substituent(s) selected from a group consisting of deuterium, (C1-C60)alkyl with or without halogen substituent(s), (C1-C60)alkoxy, (C3-C60)cycloalkyl, halogen, cyano, tri(C1-C60)alkylsilyl, di(C1-C60)alkyl(C6-C60)arylsilyl and tri(C6-C60)arylsilyl; (C1-C60)alkyl with or without halogen substituent(s), (C1-C60)alkoxy, (C3-C60)cycloalkyl, halogen, cyano, tri(C1-C60)alkylsilyl, di(C1-C60)alkyl(C6-C60)arylsilyl and tri(C6-C60)arylsilyl; and
b, c, d and e independently represent an integer from 0 to 4.

The hosts represented by Chemical Formula (10) or (11) can be exemplified by the derivatives represented by one of Chemical Formulas (12) to (14).

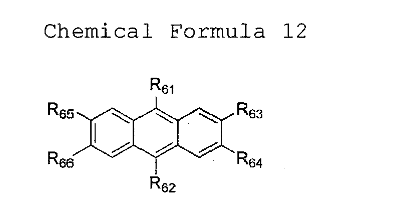

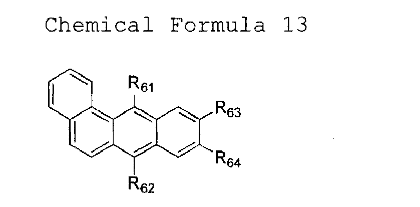

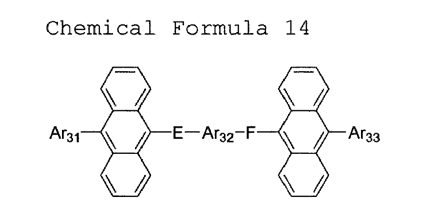

In Chemical Formulas (12) to (14),
R₆₁ and R₆₂ independently represent (C6-C60) aryl, (C4-C60)heteroaryl, a 5- or 6-membered heterocycloalkyl containing one or more heteroatom(s) selected from N, O and S, or (C3-C60)cycloalkyl; and the aryl or heteroaryl of R₆₁ and R₆₂ may be further substituted by one or more substituent(s) selected from a group consisting of deuterium, (C1-C60)alkyl, halo(C1-C60)alkyl, (C1-C60)alkoxy, (C3-C60)cycloalkyl, (C6-C60)aryl, (C4-C60)heteroaryl, halogen, cyano, tri(C1-C60)alkylsilyl, di(C1-C60)alkyl(C6-C60)arylsilyl and tri(C6-C60)arylsilyl;
R₆₃ through R₆₆ represent hydrogen, deuterium, (C1-C60)alkyl, (C1-C60)alkoxy, halogen, (C4-C60)heteroaryl, (C5-C60)cycloalkyl or (C6-C60)aryl; and the heteroaryl, cycloalkyl or aryl of R₆₃ through R₆₆ may be further substituted by one or more substituent(s) selected from a group consisting of (C1-C60)alkyl with or without halogen substituent(s), deuterium, (C1-C60)alkoxy, (C3-C60)cycloalkyl, halogen, cyano, tri(C1-C60)alkylsilyl, di(C1-C60)alkyl(C6-C60)arylsilyl and tri(C6-C60)arylsilyl;
E and F independently represent a chemical bond, or (C6-C60)arylene with or without one or more substituent(s) selected from deuterium, (C1-C60)alkyl, (C1-C60)alkoxy, (C6-C60)aryl, (C4-C60)heteroaryl and halogen;
Ar₃₁ and Ar₃₃ represent aryl selected from the following structures, or (C4-C60)heteroaryl, and the aryl or heteroaryl of Ar₃₁ and Ar₃₃ may be substituted by one or more substituent(s) selected from (C1-C60)alkyl, (C1-C60)alkoxy, (C6-C60)aryl and (C4-C60)heteroaryl: 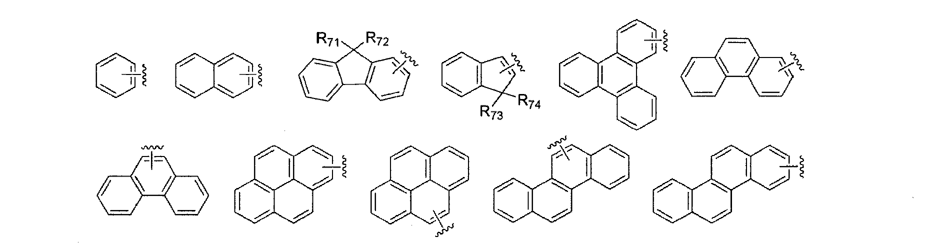 wherein, Ar₃₂ is selected from (C6-C60)arylene or (C4-C60)heteroarylene, preferably from phenylene, naphthylene, anthrylene, fluorenylene, phenanthrylene, tetracenylene, naphthacenylene, chrysenylene, pentacenylene, pyrenylene, heteroarylene and the compounds represented by the following structural formulas; and the arylene or heteroarylene of Ar₃₂ may be substituted by one or more substituent(s) selected from deuterium, (C1-C60)alkyl, (C1-C60)alkoxy, (C6-C60)aryl, (C4-C60)heteroaryl and halogen; 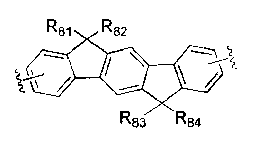
R₇₁ through R₇₄ independently represent hydrogen, deuterium, (C1-C60)alkyl or (C6-C60)aryl, or each of them may be linked to an adjacent substituent via (C3-C60)alkylene or (C3-C60)alkenylene with or without a fused ring to form an alicyclic ring, or a monocyclic or polycyclic aromatic ring;
R₈₁ through R₈₄ independently represent hydrogen, deuterium, (C1-C60)alkyl, (C1-C60)alkoxy, (C6-C60)aryl, (C4-C60)heteroaryl or halogen, or each of them may be linked to an adjacent substituent via (C3-C60)alkylene or (C3-C60)alkenylene with or without a fused ring to form an alicyclic ring, or a monocyclic or polycyclic aromatic ring.

The electroluminescent layer means the layer where electroluminescence occurs, and it may be a single layer or a multi-layer consisting of two or more layers laminated. When a mixture of host-dopant is used according to the construction of the present invention, noticeable improvement in luminous efficiency due to the inventive electroluminescent host could be confirmed. This can be achieved by the doping concentration of 0.5 to 10%. The host according to the present invention exhibits higher hole and electron conductivity, and excellent stability of the material as compared to other conventional host materials, and provides improved device life as well as luminous efficiency.

Thus, it can be described that use of the compound represented by one of Chemical Formulas (10) to (14) as an electroluminescent host significantly supplements electronic drawback of the organic electroluminescent compounds of Chemical Formula (1) according to the present invention.

The host compounds represented by one of Chemical Formulas (12) to (14) can be exemplified by the following compounds, but are not restricted thereto.

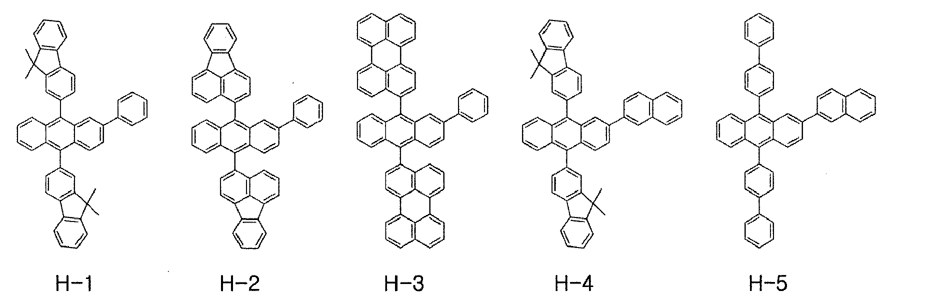

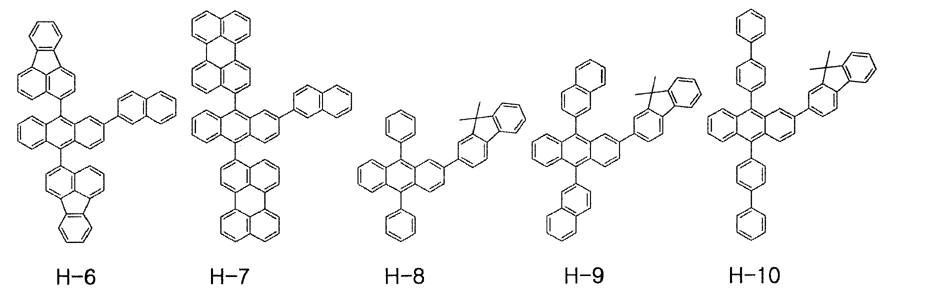

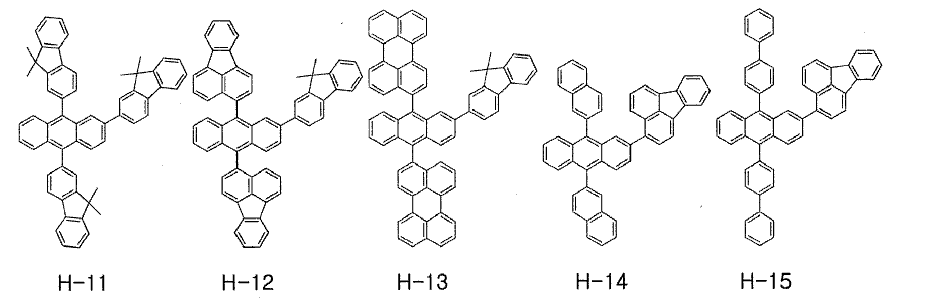

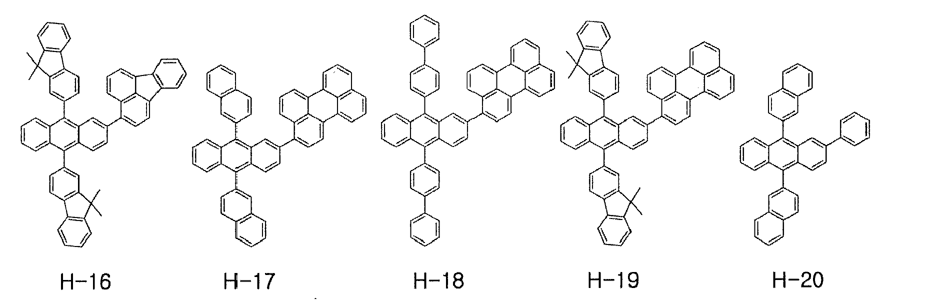

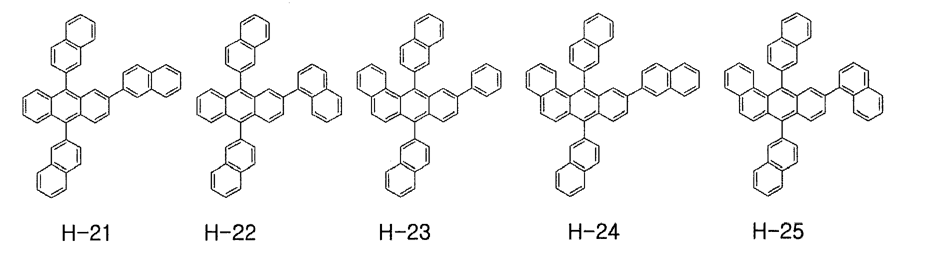

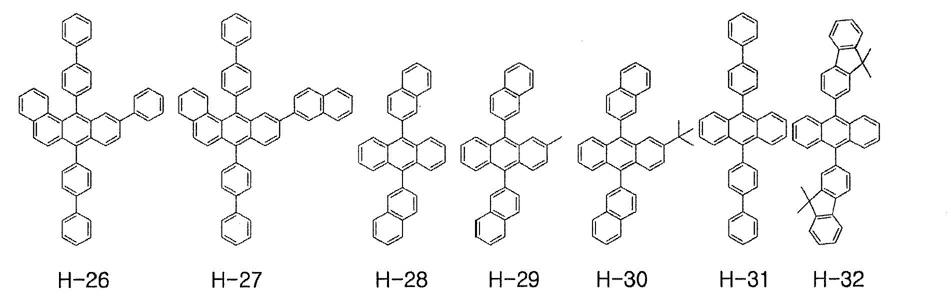

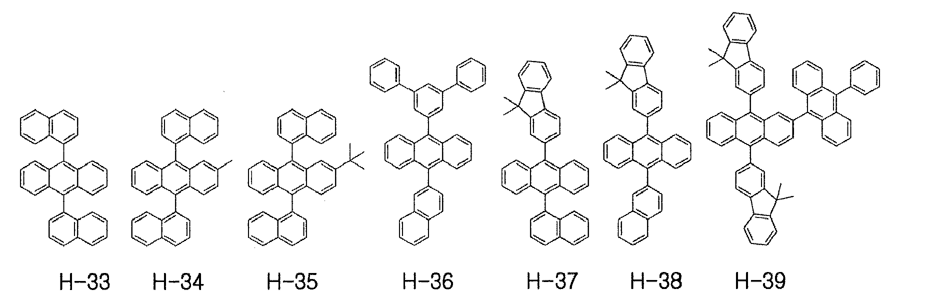

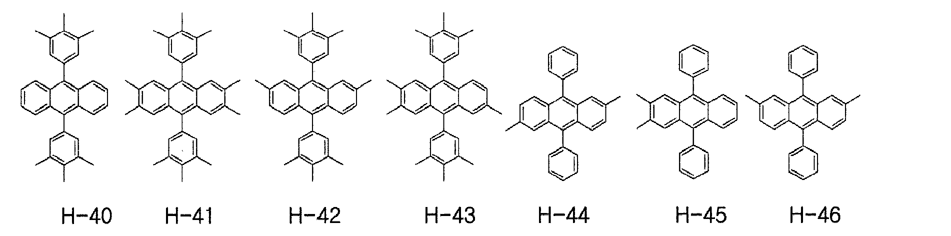

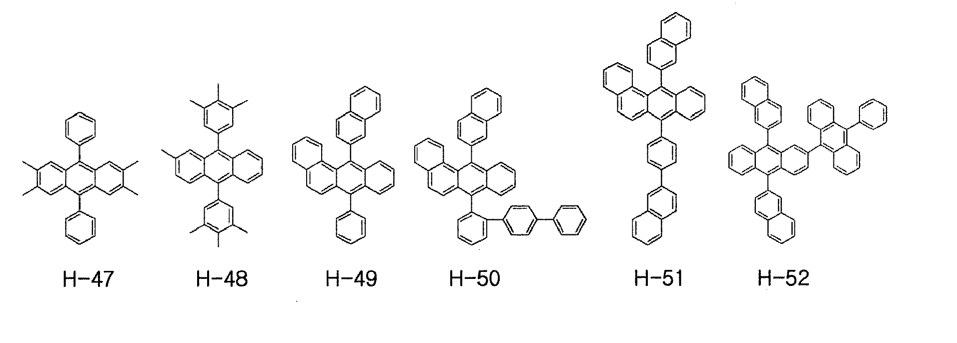

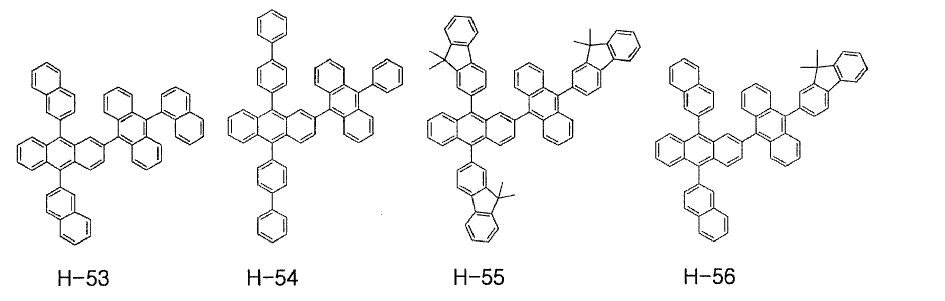

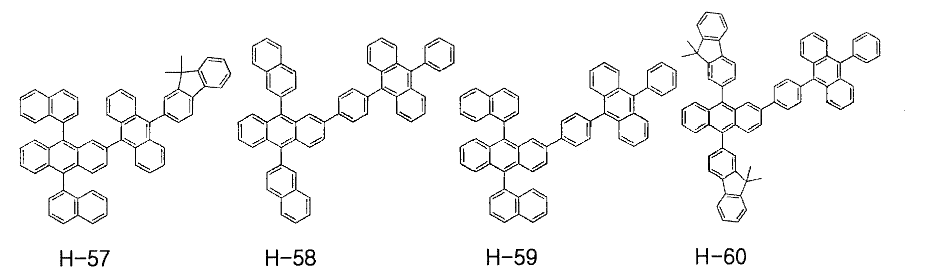

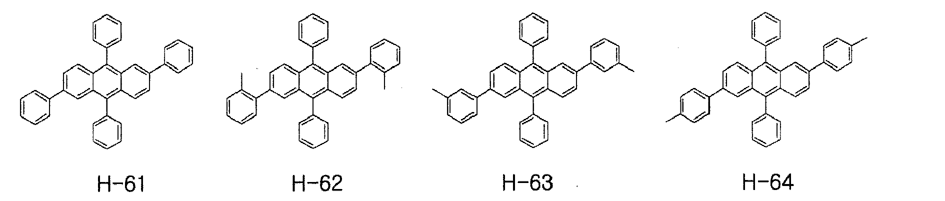

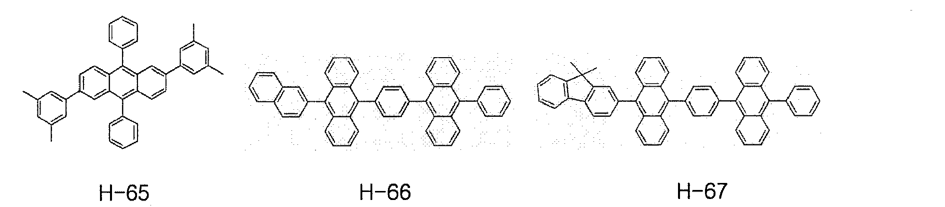

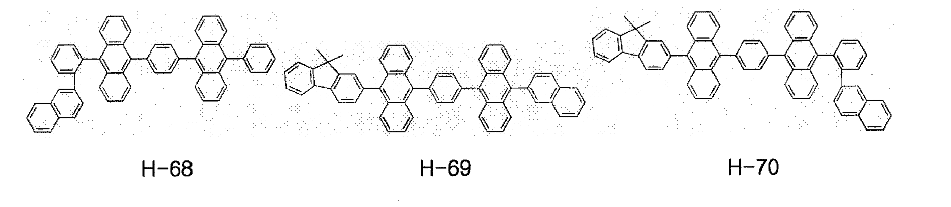

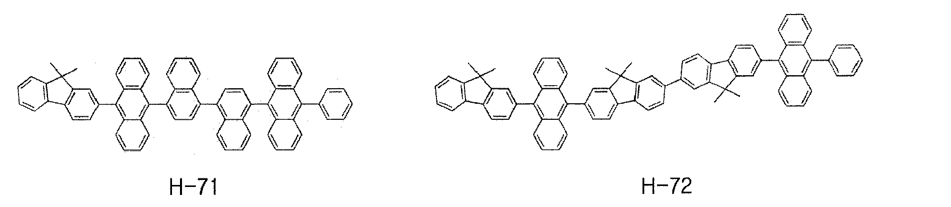

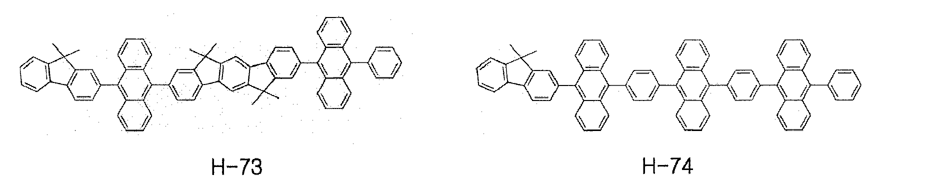

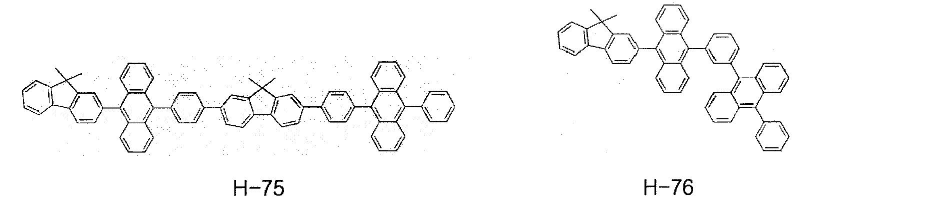

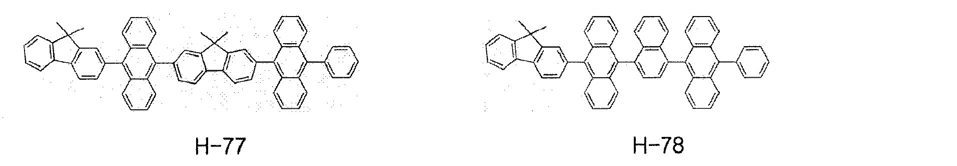

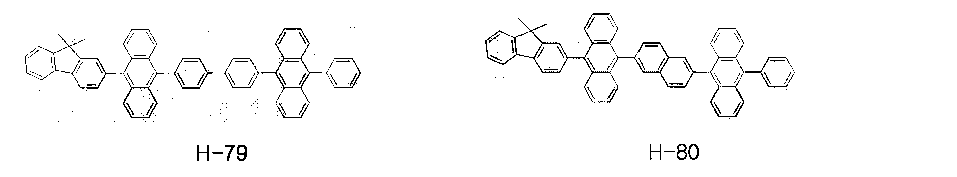

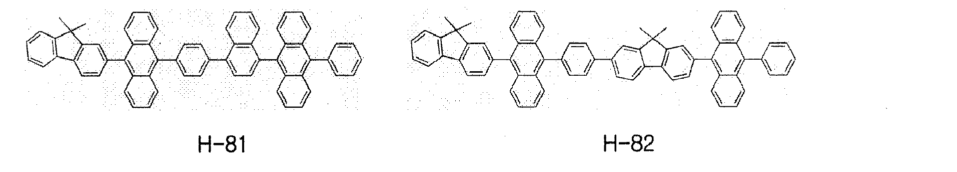

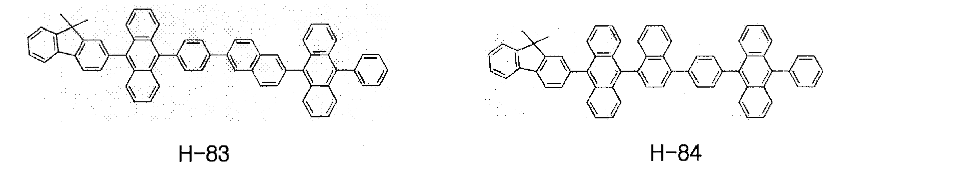

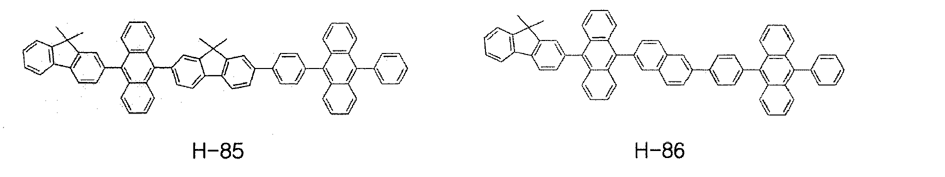

The organic electroluminescent device according to the invention may further comprise one or more compound(s) selected from arylamine compounds and styrylarylamine compounds, as well as the organic electroluminescent compound represented by Chemical Formula (1). Examples of the arylamine or styrylarylamine compounds include the compounds represented by Chemical Formula (15), but they are not restricted thereto: 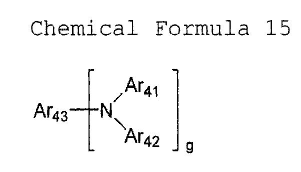 wherein, Ar₄₁ and Ar₄₂ independently represent (C1-C60)alkyl, (C6-C60)aryl, (C4-C60)heteroaryl, (C6-C60)arylamino, (C1-C60)alkylamino, a 5- or 6-membered heterocycloalkyl containing one or more heteroatom(s) selected from N, O and S, or (C3-C60)cycloalkyl, or Ar₄₁ and Ar₄₂ may be linked via (C3-C60)alkylene or (C3-C60)alkenylene with or without a fused ring to form an alicyclic ring, or a monocyclic or polycyclic aromatic ring;
when g is 1, Ar₄₃ represents (C6-C60)arylamino, (C6-C60)aryl, (C4-C60)heteroaryl, or a substituent represented by one of the following structural formulas: 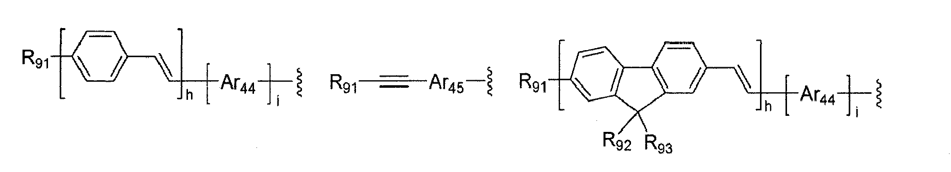 when g is 2, Ar₄₃ represents (C6-C60)arylene, (C4-C60)heteroarylene, or a substituent selected from the following structures: 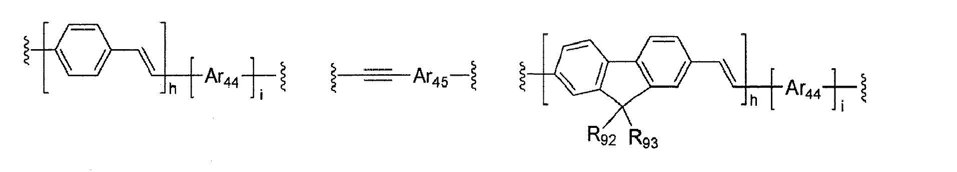 wherein Ar₄₄ and Ar₄₅ independently represent (C6-C60)arylene or (C4-C60)heteroarylene;
R₉₁ through R₉₃ independently represent hydrogen, deuterium, (C1-C60)alkyl or (C6-C60)aryl;
h is an integer from 1 to 4, and i is an integer of 0 or 1;
the alkyl, aryl, heteroaryl, arylamino, alkylamino, cycloalkyl or heterocycloalkyl of Ar₄₁ and Ar₄₂; the arylamino, aryl, heteroaryl, arylene or heteroarylene of Ar₄₃; the arylene or heteroarylene of Ar₄₄ and Ar₄₅; or the alkyl or aryl of R₉₁ through R₉₃ may be further substituted by one or more substituent(s) selected from a group consisting of deuterium, halogen, (C1-C60)alkyl, (C6-C60)aryl, (C4-C60)heteroaryl, a 5-or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60) alkenyl, (C2-C60)alkynyl, cyano, (C1-C60)alkylamino, (C6-C60)arylamino, (C6-C60)ar(C1-C60)alkyl, (C6-C60)aryloxy, (C1-C60)alkyloxy, (C6-C60)arylthio, (C1-C60)alkylthio, (C1-C60)alkoxycarbonyl, (C1-C60)alkylcarbonyl, (C6-C60)arylcarbonyl, carboxyl, nitro and hydroxyl.

The arylamine compounds or styrylarylamine compounds may be more specifically exemplified by the following compounds, but they are not restricted thereto.

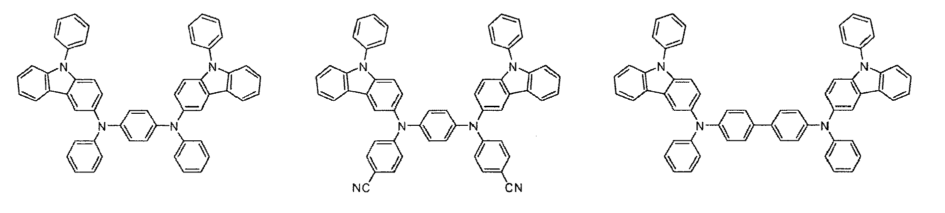

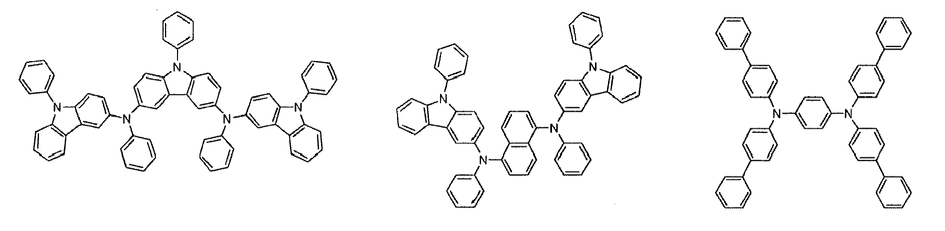

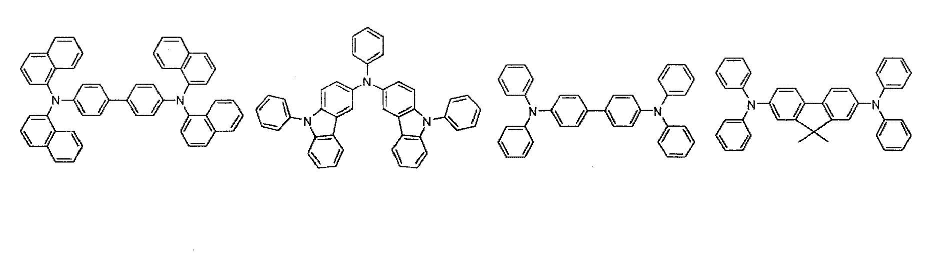

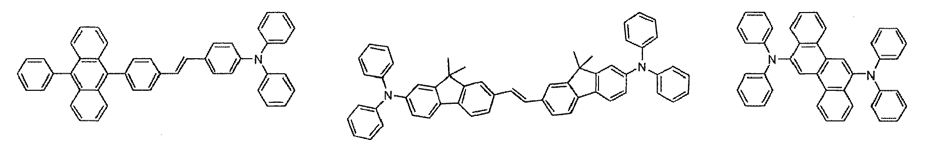

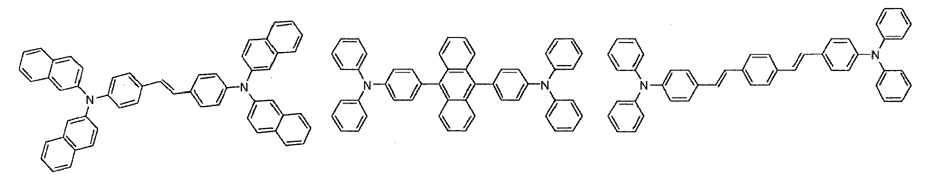

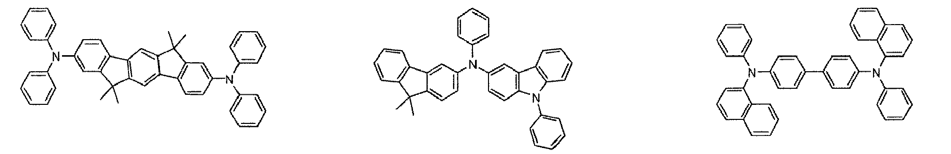

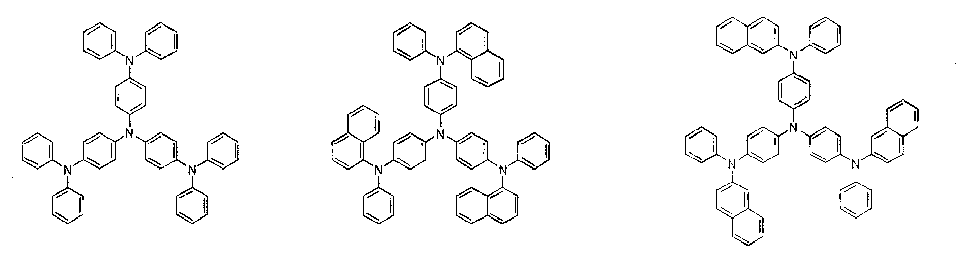

In an organic electroluminescent device according to the present invention, the organic layer may further comprise one or more metal(s) selected from a group consisting of organic metals of Group 1, Group 2, 4^{th} period and 5^{th} period transition metals, lanthanide metals and d-transition elements from the Periodic Table of Elements, as well as the organic electroluminescent compound represented by Chemical Formula (1). The organic layer may comprise a charge generating layer, in addition to an electroluminescent layer.

The present invention can realize an organic electroluminescent device having a pixel structure of independent light-emitting mode, which comprises an organic electroluminescent device containing the compound of Chemical Formula (1) as a sub-pixel, and one or more sub-pixel(s) comprising one or more metallic compound(s) selected from a group consisting of Ir, Pt, Pd, Rh, Re, Os, Tl, Pb, Bi, In, Sn, Sb, Te, Au and Ag, patterned in parallel at the same time.

Further, the organic electroluminescent device may be a white organic electroluminescent device wherein the organic layer comprises, in addition to the organic electroluminescent compound described above, one or more compound(s) selected from compounds having the electroluminescent peak of wavelength of not more than 500 nm, and those having the electroluminescent peak of wavelength of not less than 560 nm, at the same time. Those compounds may be exemplified by the compounds represented by one of Chemical Formulas (16) to (23), but they are not restricted thereto.

Chemical Formula 16 M¹L¹L²L³

In Chemical Formula (16), M¹ is selected from Group 7, 8, 9, 10, 11, 13, 14, 15 and 16 metals in the Periodic Table of Elements, and ligands L¹, L² and L³ are independently selected from the following structures: 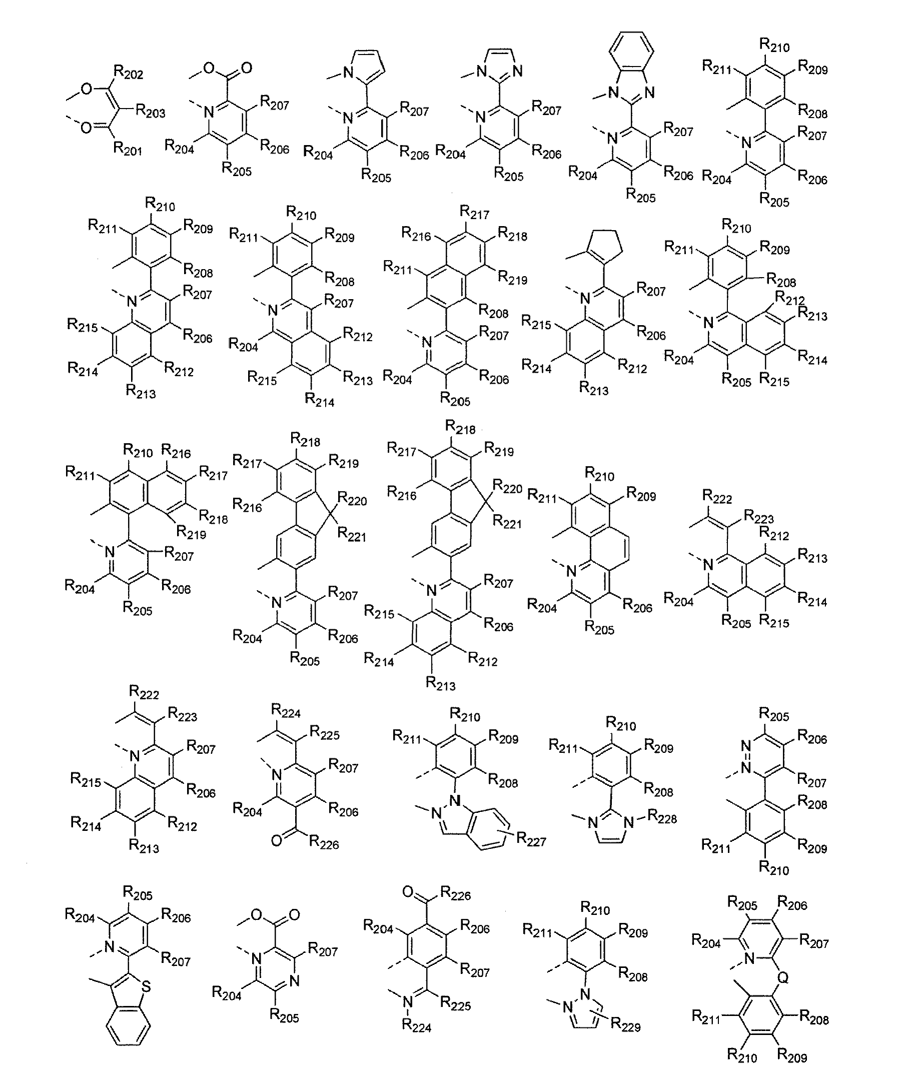 wherein, R₂₀₁ through R₂₀₃ independently represent hydrogen, deuterium, (C1-C60)alkyl with or without halogen substituent(s), (C6-C60)aryl with or without (C1-C60)alkyl substituent(s), or halogen;
R₂₀₄ through R₂₁₉ independently represent hydrogen, deuterium, (C1-C60)alkyl, (C1-C30)alkoxy, (C3-C60)cycloalkyl, (C2-C30)alkenyl, (C6-C60)aryl, mono or di(C1-C30)alkylamino, mono or di(C6-30)arylamino, SF₅, tri(C1-C30)alkylsilyl, di(C1-C30)alkyl(C6-C30)arylsilyl, tri(C6-C30)arylsilyl, cyano or halogen; and the alkyl, cycloalkyl, alkenyl or aryl of R₂₀₄ through R₂₁₉ may be further substituted by one or more substituent(s) selected from deuterium, (C1-C60)alkyl, (C6-C60)aryl and halogen;
R₂₂₀ through R₂₂₃ independently represent hydrogen, deuterium, (C1-C60)alkyl with or without halogen substituent(s), or (C6-C60)aryl with or without (C1-C60)alkyl substituent(s);
R₂₂₄ and R₂₂₅ independently represent hydrogen, deuterium, (C1-C60) alkyl, (C6-C60)aryl or halogen, or R₂₂₄ and R₂₂₅ may be linked via (C3-C12)alkylene or (C3-C12)alkenylene with or without a fused ring to form an alicyclic ring, or a monocyclic or polycyclic aromatic ring; and the alkyl or aryl of R₂₂₄ and R₂₂₅, or the alicyclic ring, or the monocyclic or polycyclic aromatic ring formed therefrom via (C3-C12)alkylene or (C3-C12)alkenylene with or without a fused ring may be further substituted by one or more substituent(s) selected from deuterium, (C1-C60)alkyl with or without halogen substituent(s), (C1-C30)alkoxy, halogen, tri(C1-C30)alkylsilyl, tri(C6-C30)arylsilyl and (C6-C60)aryl;
R₂₂₆ represents (C1-C60)alkyl, (C6-C60)aryl, (C5-C60)heteroaryl or halogen;
R₂₂₇ through R₂₂₉ independently represent hydrogen, deuterium, (C1-C60)alkyl, (C6-C60)aryl or halogen, and the alkyl or aryl of R₂₂₆ through R₂₂₉ may be further substituted by deuterium, halogen or (C1-C60)alkyl;
Q represents 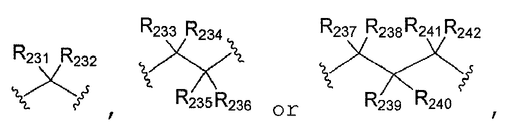 and R₂₃₁
   through R₂₄₂ independently represent hydrogen, deuterium, (C1-C60)alkyl with or without halogen substituent(s), (C1-C30)alkoxy, halogen, (C6-C60)aryl, cyano or (C5-C60)cycloalkyl, or each of R₂₃₁ through R₂₄₂ may be linked to an adjacent substituent via alkylene or alkenylene to form a (C5-C7) spiro-ring or (C5-C9) fused ring, or each of them may be linked to R₂₀₇ or R₂₀₈ via alkylene or alkenylene to form a (C5-C7) fused ring.

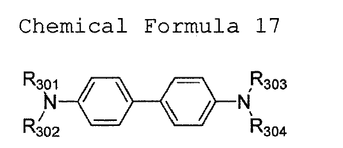

In Chemical Formula (17), R₃₀₁ through R₃₀₄ independently represent (C1-C60)alkyl or (C6-C60)aryl, or each of them may be linked to an adjacent substituent via (C3-C60)alkylene or (C3-C60)alkenylene with or without a fused ring to form an alicyclic ring, or a monocyclic or polycyclic aromatic ring; and the alkyl or aryl of R₃₀₁ through R₃₀₄, or the alicyclic ring, or the monocyclic or polycyclic aromatic ring formed therefrom by linkage via (C3-C60)alkylene or (C3-C60)alkenylene with or without a fused ring may be further substituted by one or more substituent(s) selected from deuterium, (C1-C60)alkyl with or without halogen substituent(s), (C1-C60)alkoxy, halogen, tri(C1-C60)alkylsilyl, tri(C6-C60)arylsilyl and (C6-C60)aryl.

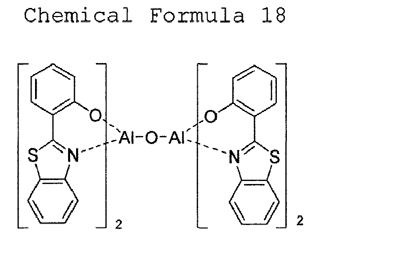

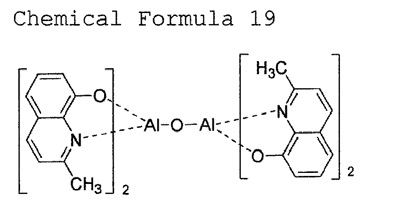

Chemical Formula 20 L⁴L⁵M²(T)ⱼ

In Chemical Formula (20), the ligands, L⁴ and L⁵ are independently selected from the following structures: 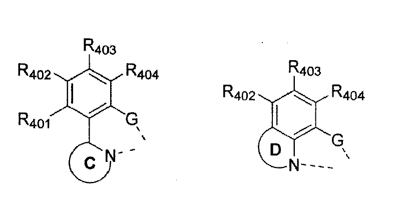 wherein, M² is a bivalent or trivalent metal;
j is 0 when M² is a bivalent metal, while j is 1 when M² is a trivalent metal;
T represents (C6-C60)aryloxy or tri(C6-C60)arylsilyl, and the aryloxy and triarylsilyl of T may be further substituted by (C1-C60)alkyl or (C6-C60)aryl;
G represents O, S or Se;
ring C represents oxazole, thiazole, imidazole, oxadiazole, thiadiazole, benzoxazole, benzothiazole, benzimidazole, pyridine or quinoline;
ring D represents pyridine or quinoline, and ring D may be further substituted by deuterium, (C1-C60)alkyl, or phenyl or naphthyl with or without (C1-C60)alkyl substituent(s);
R₄₀₁ through R₄₀₄ independently represent hydrogen, deuterium, (C1-C60)alkyl, halogen, tri(C1-C60)alkylsilyl, tri(C6-C60)arylsilyl or (C6-C60)aryl, or each of them may be linked to an adjacent substituent via (C3-C60)alkylene or (C3-C60)alkenylene to form a fused ring, and the pyridine or quinoline may form a chemical bond with R₄₀₁ to form a fused ring;
ring C or the aryl group of R₄₀₁ through R₄₀₄ may be further substituted by deuterium, (C1-C60)alkyl, halogen, (C1-C60)alkyl with halogen substituent(s), phenyl, naphthyl, tri(C1-C60)alkylsilyl, tri(C6-C60)arylsilyl or amino group.

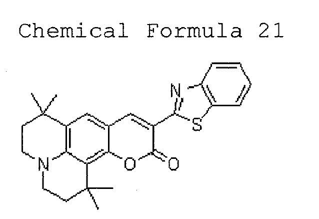

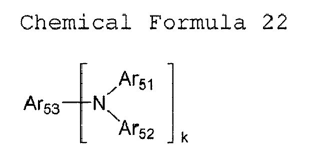

In Chemical Formula (22), Ar₅₁ and Ar₅₂ independently represent (C1-C60)alkyl, (C6-C60)aryl, (C4-C60)heteroaryl, (C6-C60)arylamino, (C1-C60)alkylamino, 5- or 6-membered heterocycloalkyl containing one or more heteroatom(s) selected from N, O and S, or (C3-C60)cycloalkyl, or Ar₅₁ and Ar₅₂ may be linked via (C3-C60)alkylene or (C3-C60)alkenylene with or without a fused ring to form an alicyclic ring, or a monocyclic or polycyclic aromatic ring;
when k is 1, Ar₅₃ represents (C6-C60)arylamino, (C6-C60)aryl, (C4-C60)heteroaryl, or a substituent represented by one of the following structural formulas: 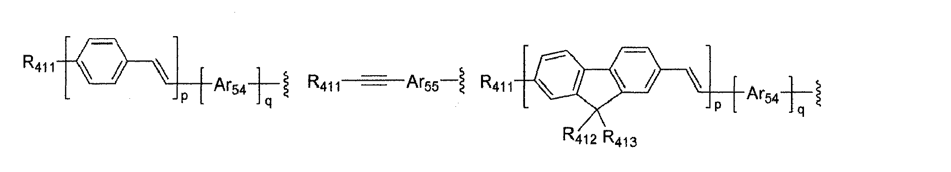 when k is 2, Ar₅₃ represents (C6-C60)arylene, (C4-C60)heteroarylene, or a substituent represented by one of the following structural formulas: 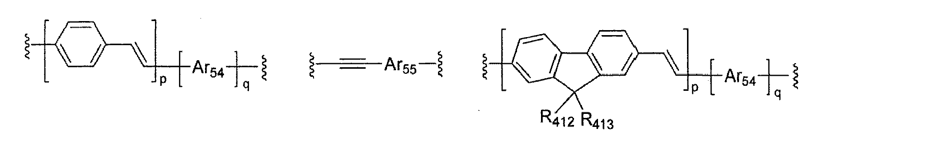 wherein Ar₅₄ and Ar₅₅ independently represent (C6-C60)arylene or (C4-C60)heteroarylene;
R₄₁₁ through R₄₁₃ independently represent hydrogen, deuterium, (C1-C60)alkyl or (C6-C60)aryl;
p is an integer from 1 to 4, q is an integer of 0 or 1; and
the alkyl, aryl, heteroaryl, arylamino, alkylamino, cycloalkyl or heterocycloalkyl of Ar₅₁ and Ar₅₂; the arylamino, aryl, heteroaryl, arylene or heteroarylene of Ar₅₃; the arylene or heteroarylene of Ar₅₄ and Ar₅₅; or the alkyl or aryl of R₄₁₁ through R₄₁₃ may be further substituted by one or more substituent(s) selected from a group consisting of deuterium, halogen, (C1-C60)alkyl, (C6-C60)aryl, (C4-C60)heteroaryl, a 5-or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C6-C60)aryloxy, (C1-C60)alkyloxy, (C6-C60)arylthio, (C1-C60)alkylthio, (C1-C60)alkoxycarbonyl, (C1-C60)alkylcarbonyl, (C6-C60)arylcarbonyl, carboxyl, nitro and hydroxyl.

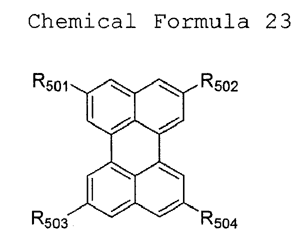

In Chemical Formula (23), R₅₀₁ through R₅₀₄ independently represent hydrogen, deuterium, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl, or each of R₅₀₁ through R₅₀₄ may be linked to an adjacent substituent via (C3-C60)alkylene or (C3-C60)alkenylene with or without a fused ring to form an alicyclic ring, or a monocyclic or polycyclic aromatic ring;
the alkyl, alkenyl, alkynyl, cycloalkyl, heterocycloalkyl, aryl, heteroaryl, arylsilyl, alkylsilyl, alkylamino or arylamino of R₅₀₁ through R₅₀₄, or the alicyclic ring, or the monocyclic or polycyclic aromatic ring formed therefrom by linkage to an adjacent substituent via (C3-C60)alkylene or (C3-C60)alkenylene with or without a fused ring may be further substituted by one or more substituent(s) selected from deuterium, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl.

The compounds having electroluminescent peak of wavelength of not more than 500 nm, or those having electroluminescent peak of wavelength of not less than 560 nm, can be exemplified by the following compounds, but they are not restricted thereto.

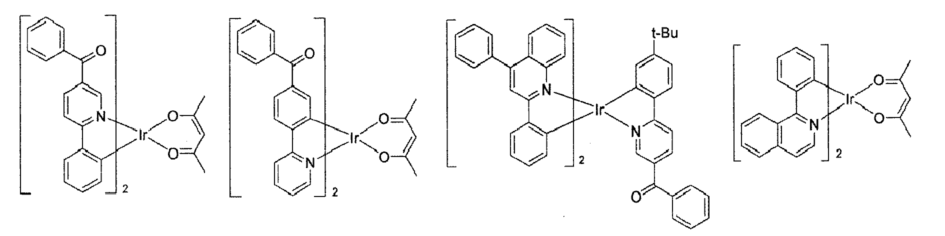

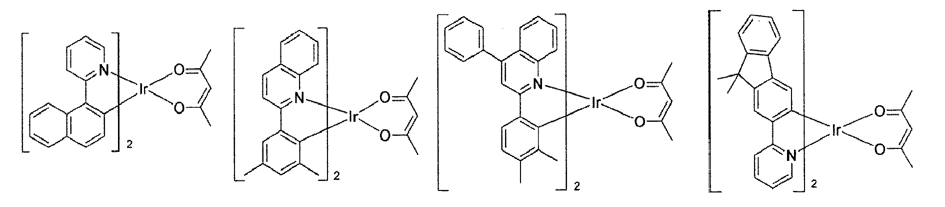

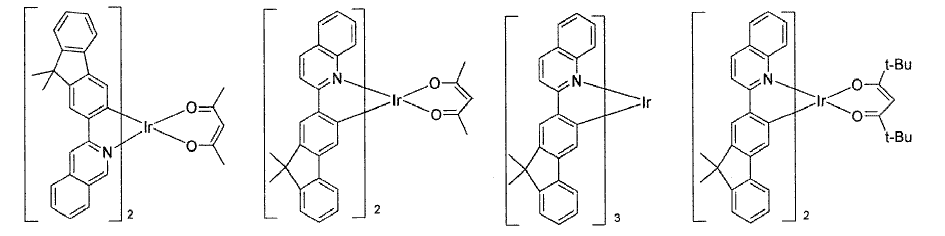

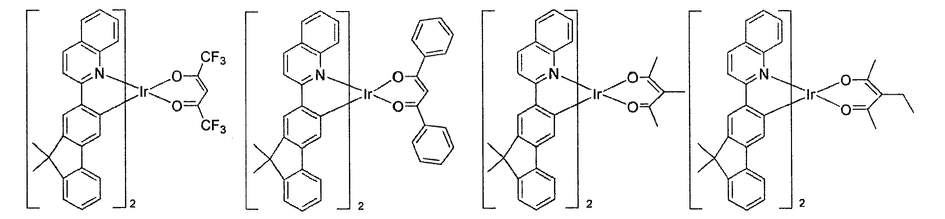

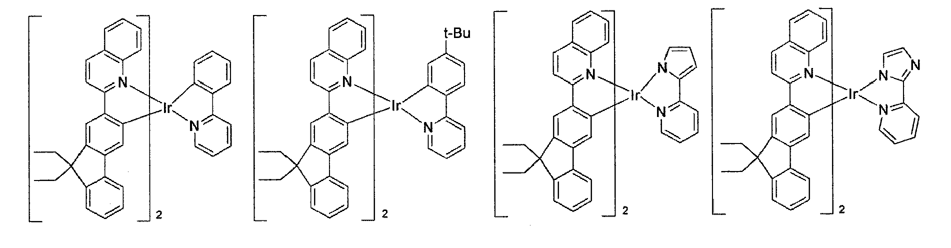

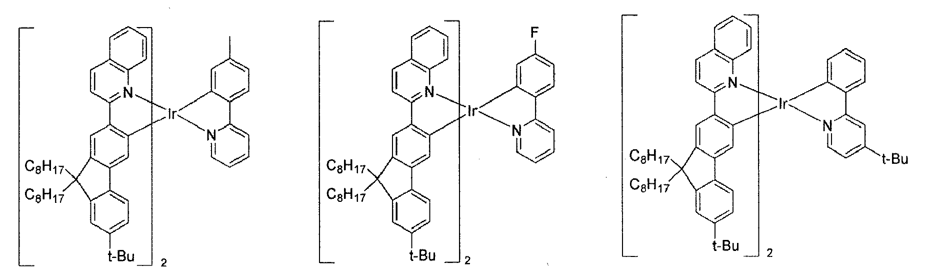

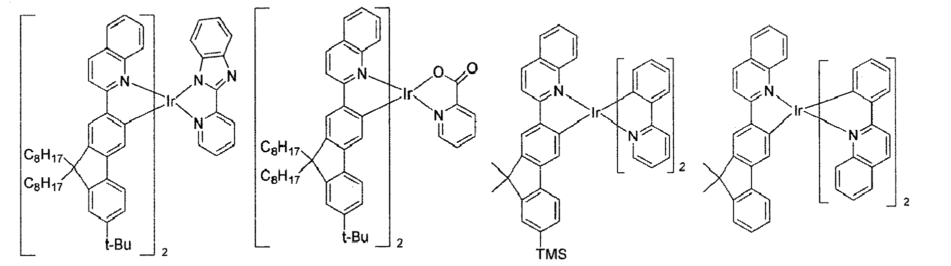

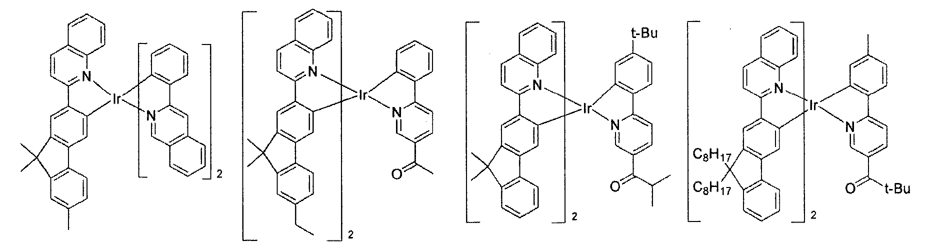

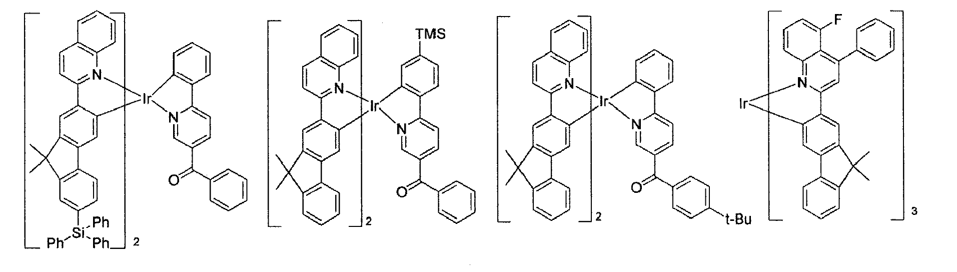

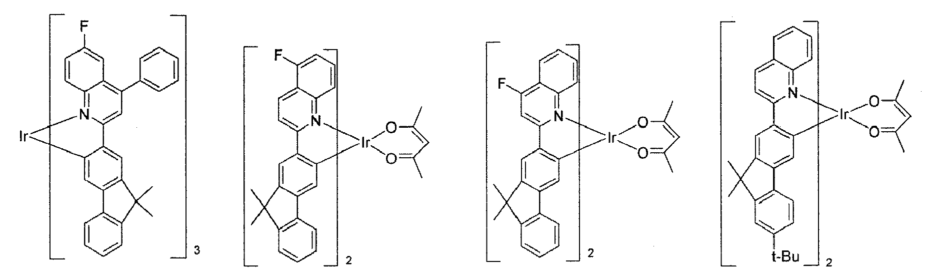

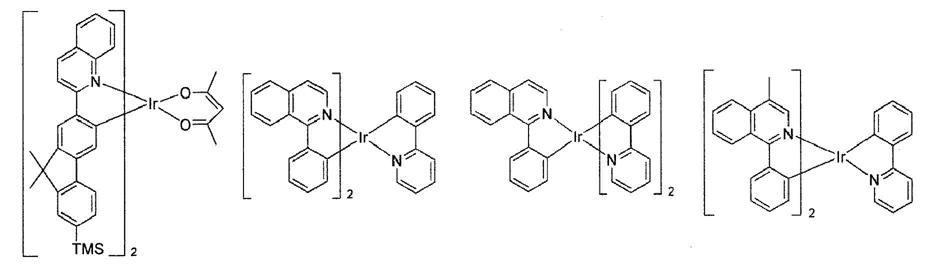

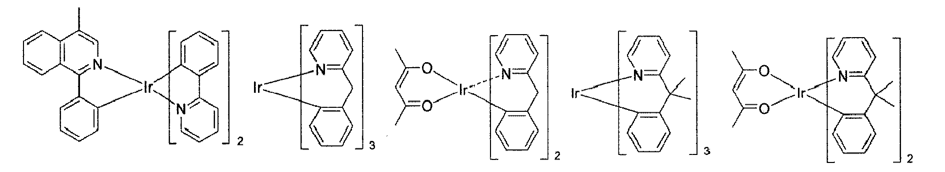

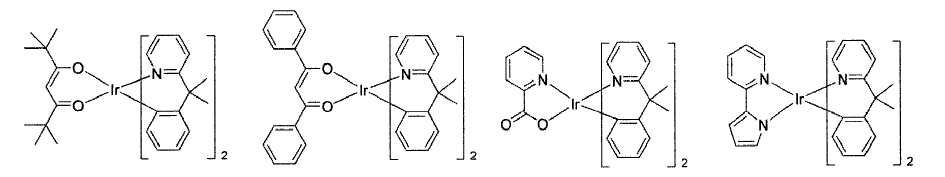

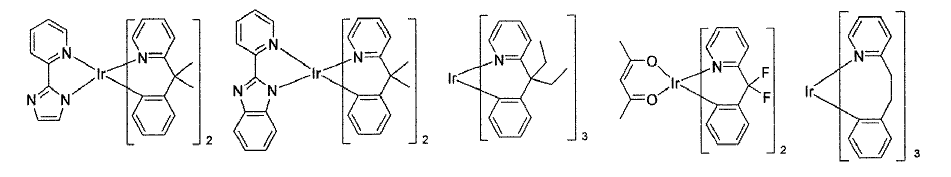

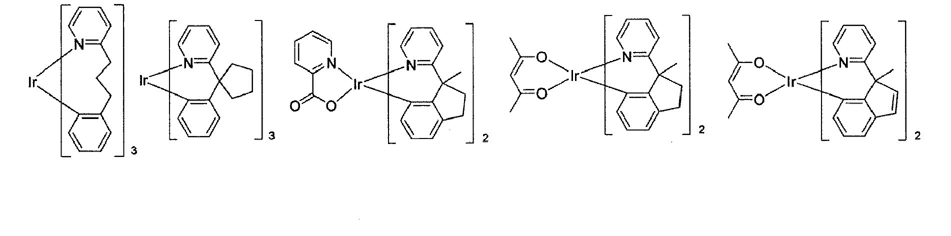

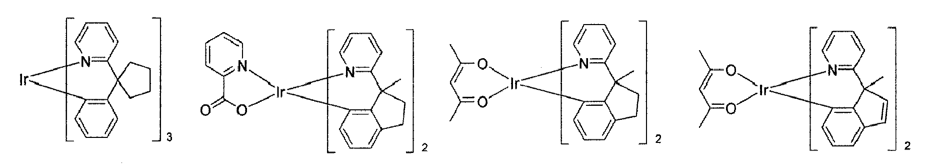

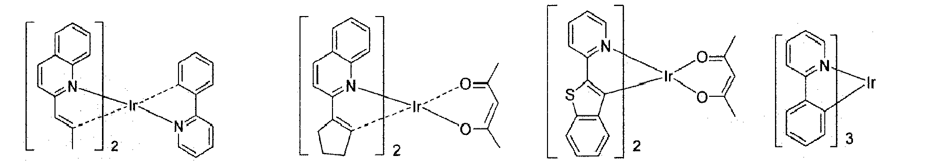

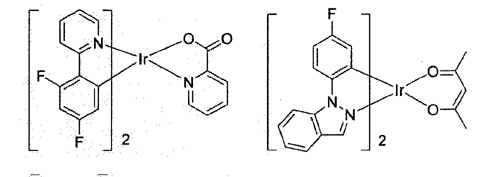

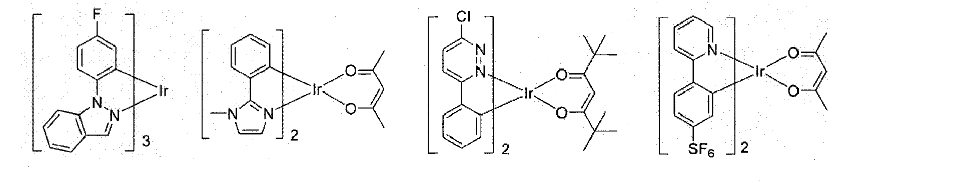

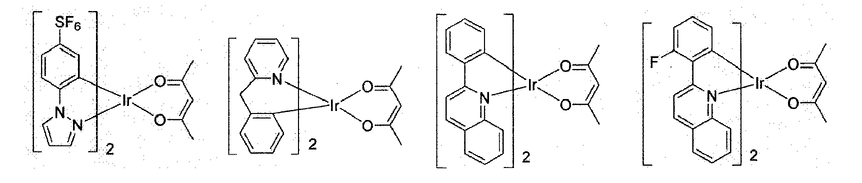

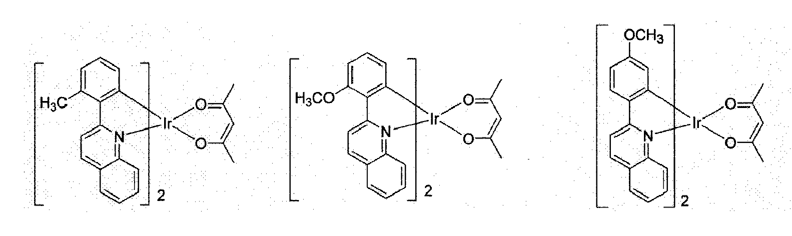

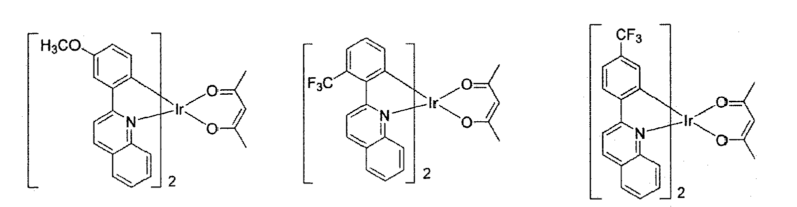

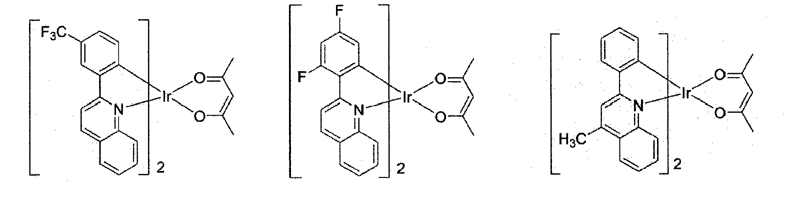

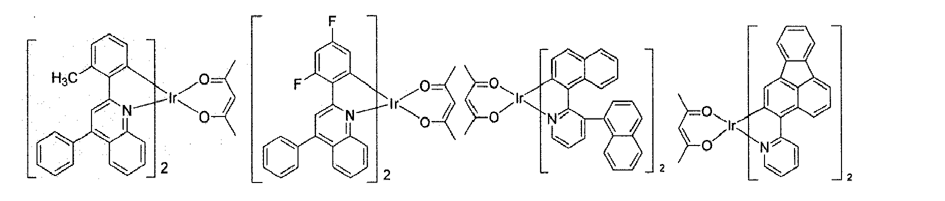

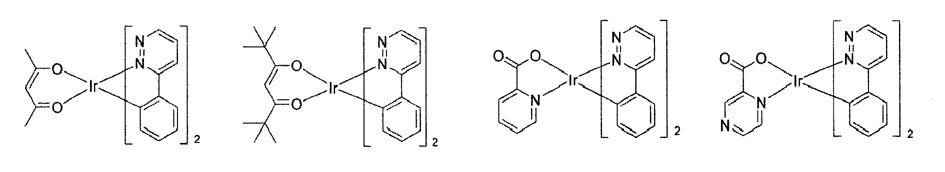

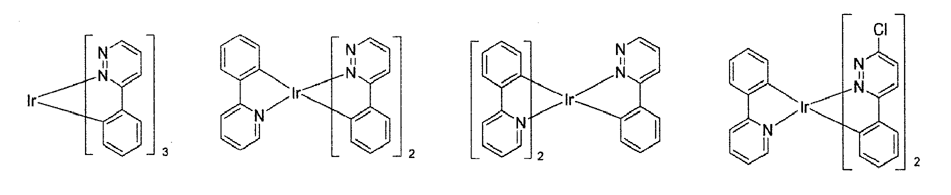

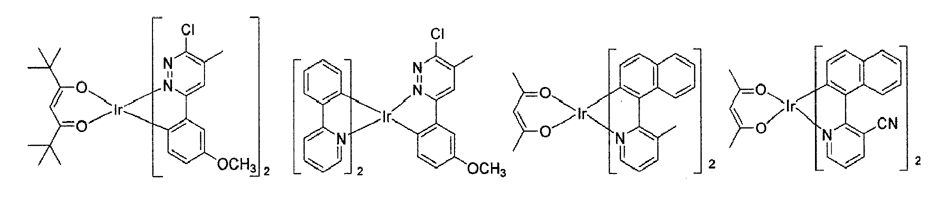

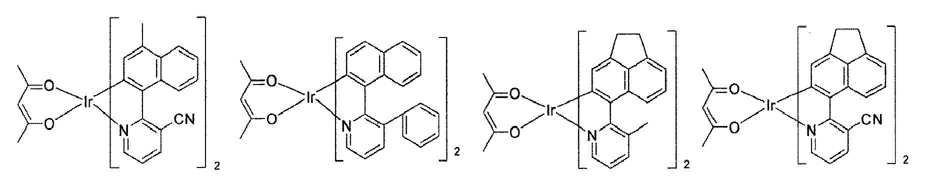

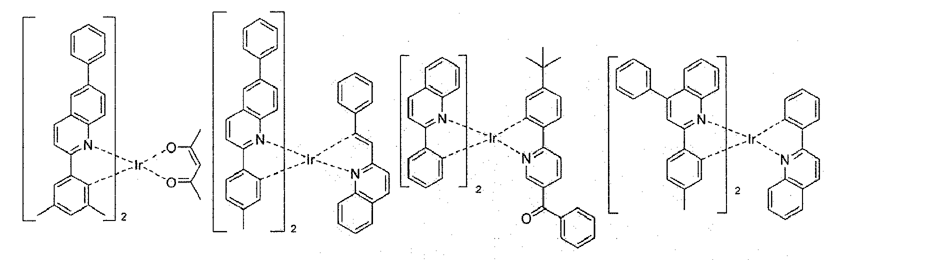

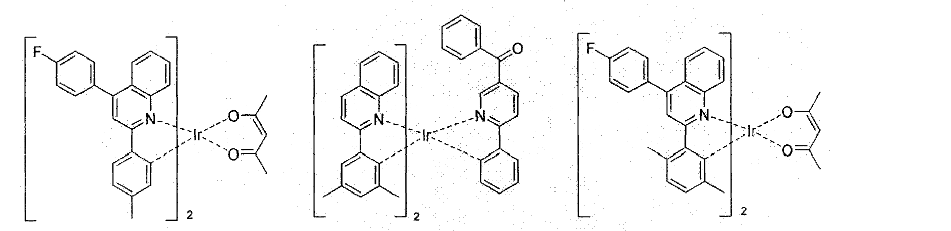

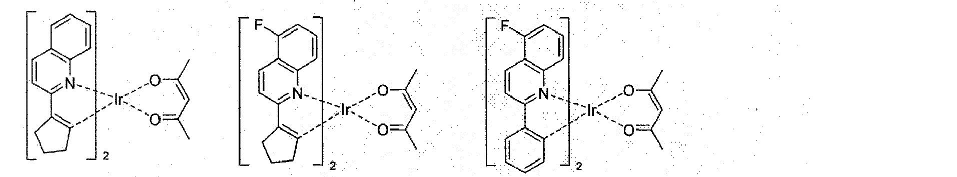

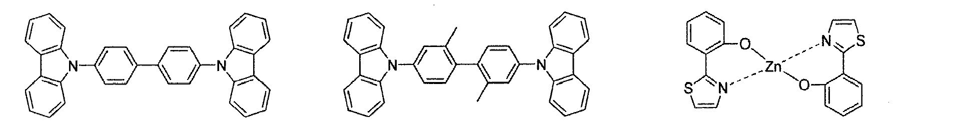

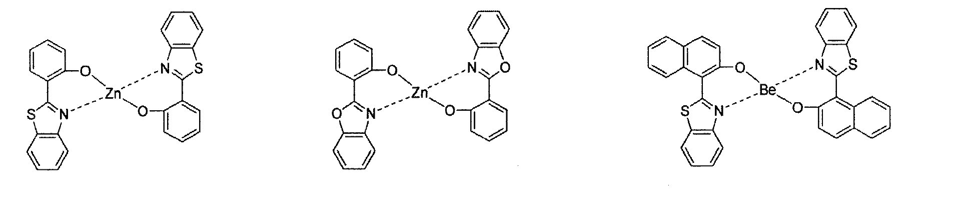

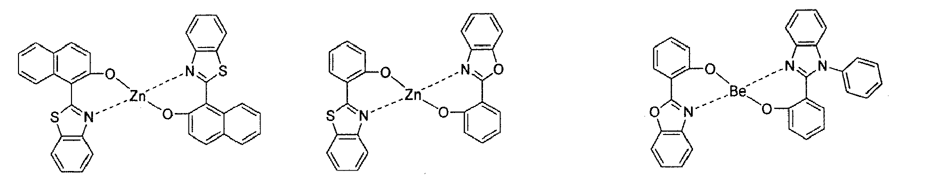

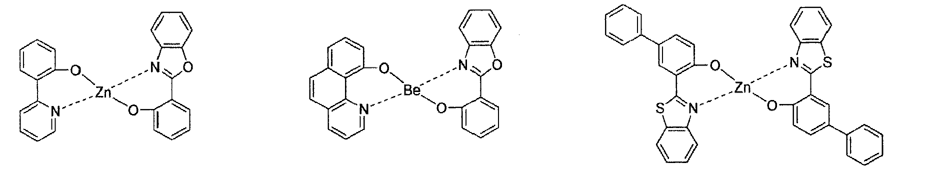

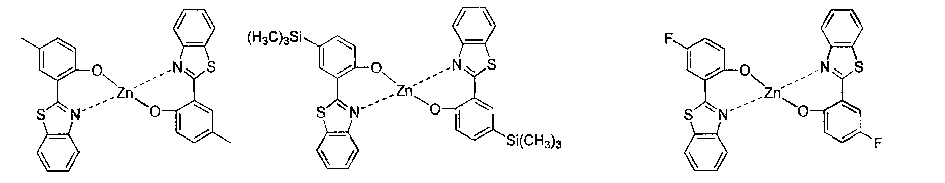

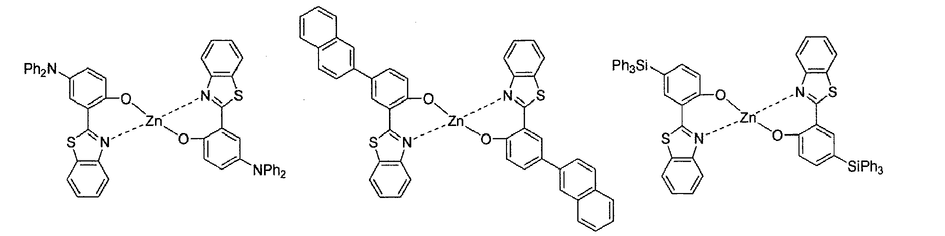

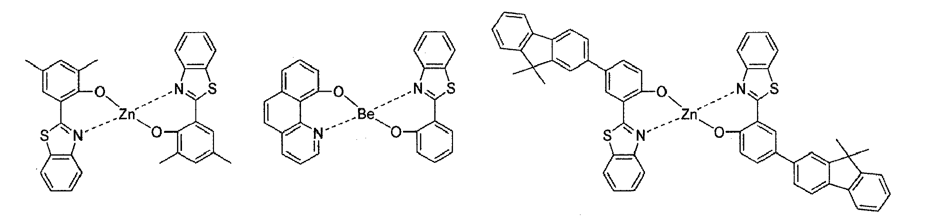

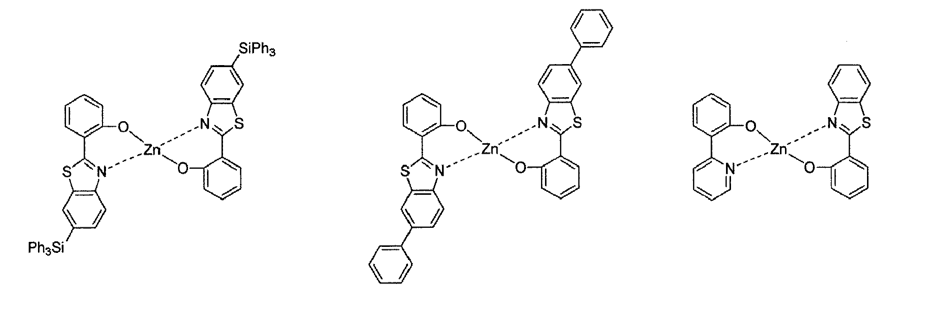

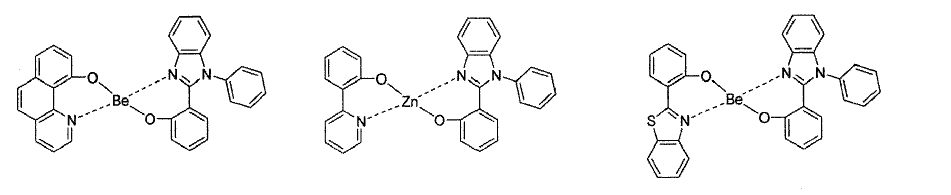

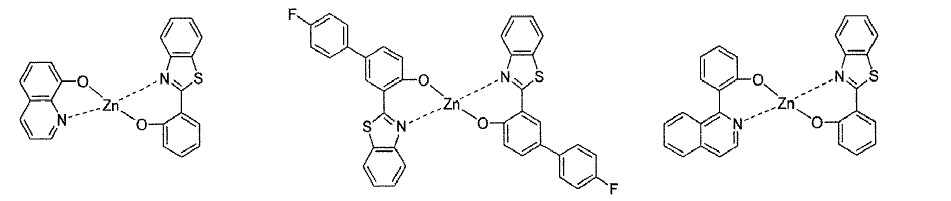

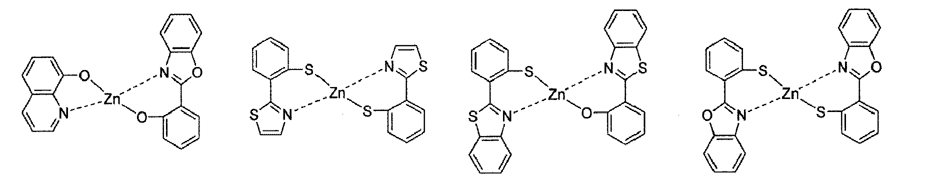

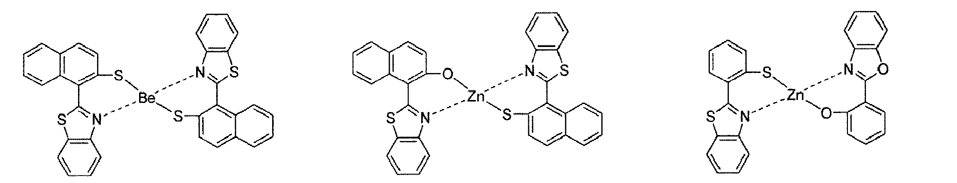

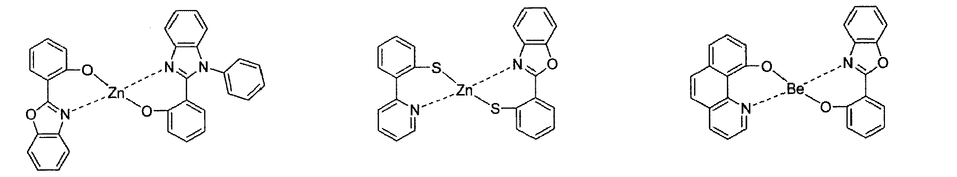

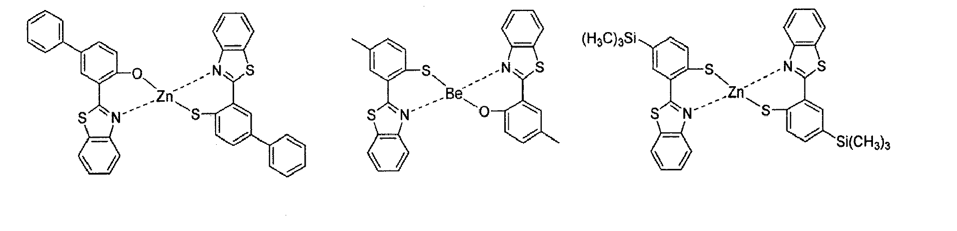

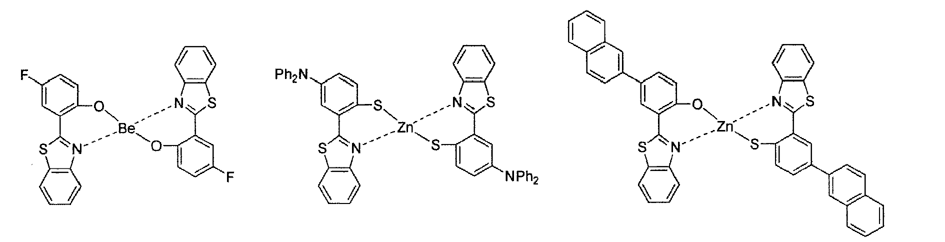

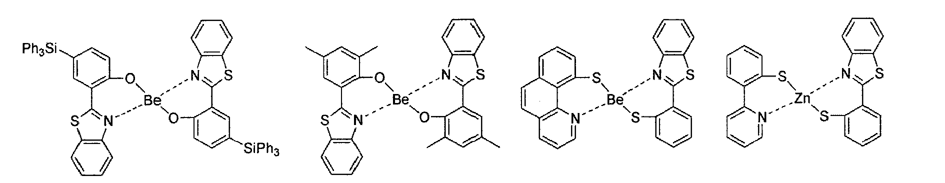

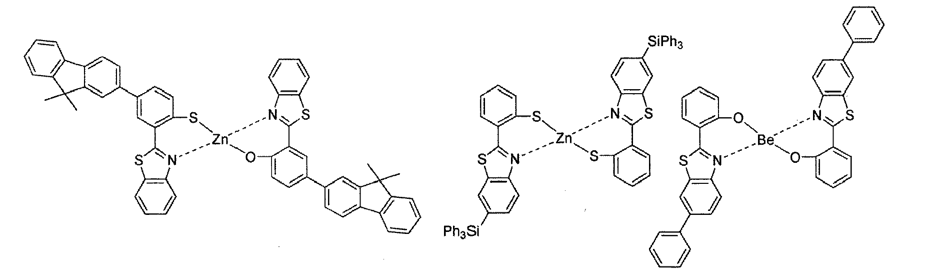

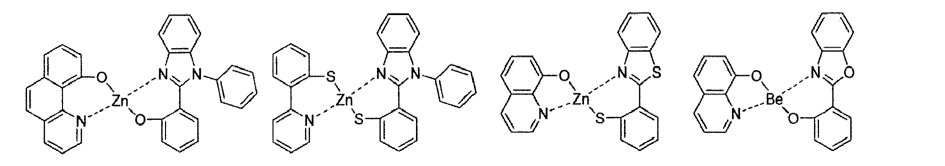

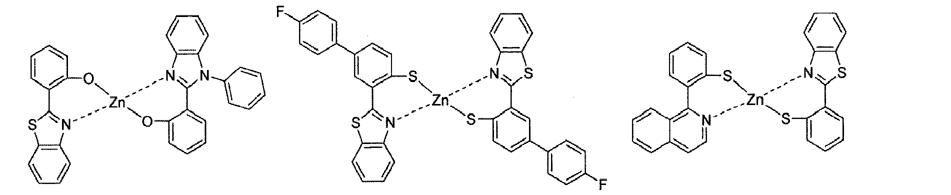

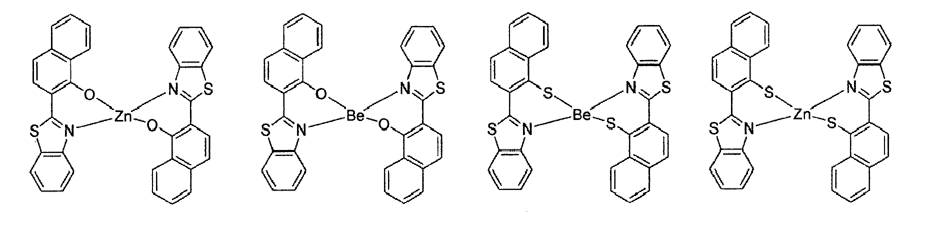

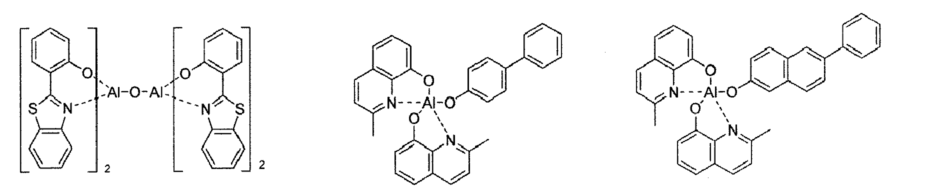

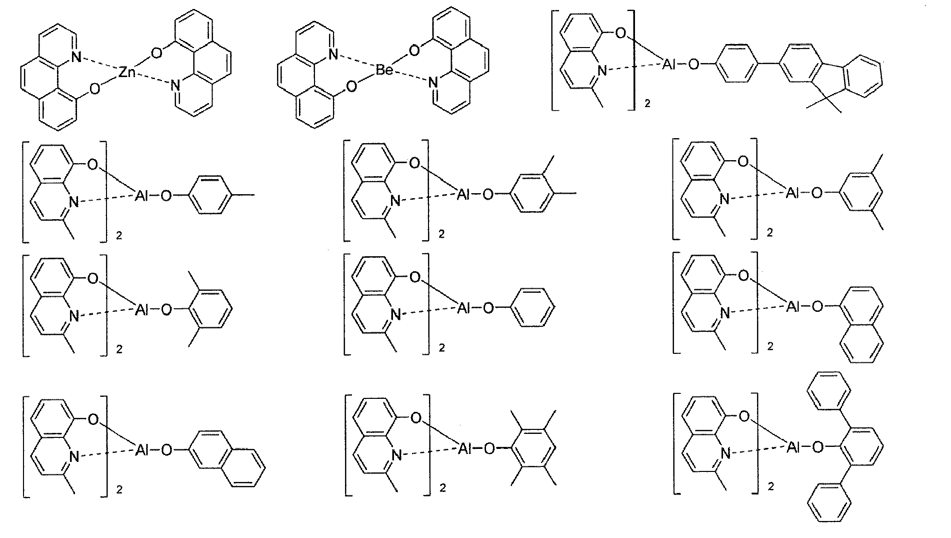

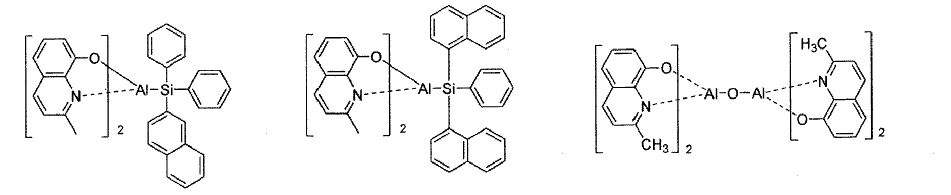

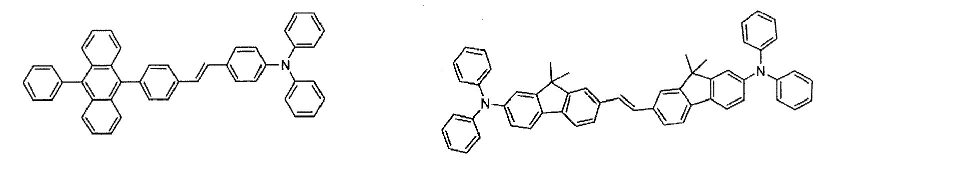

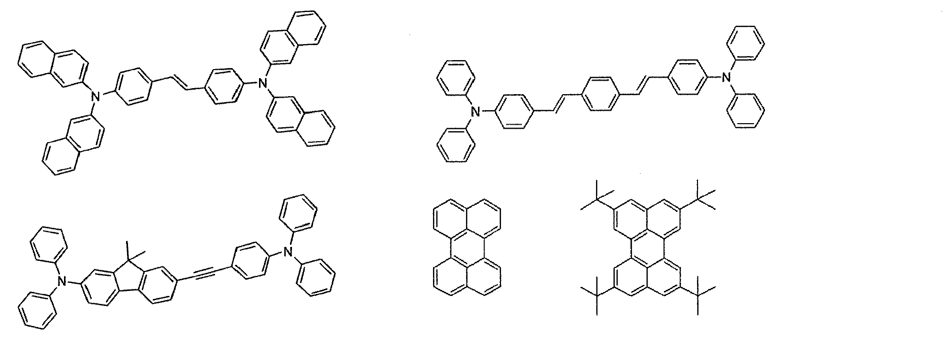

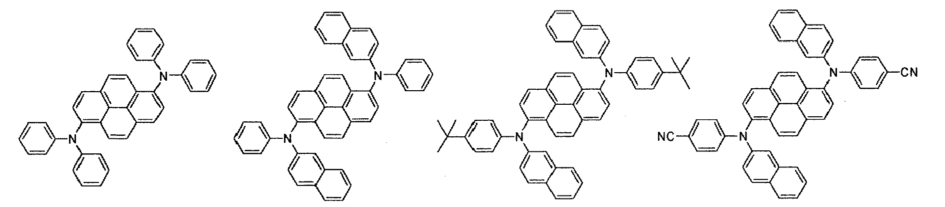

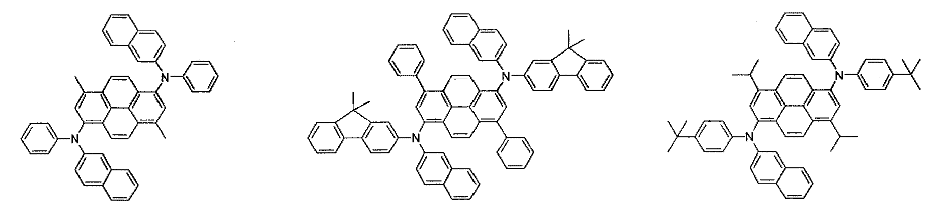

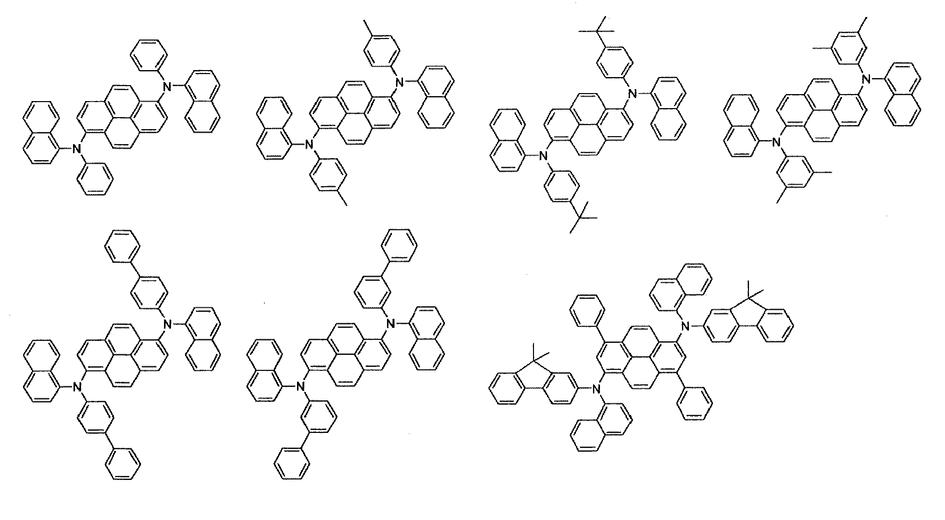

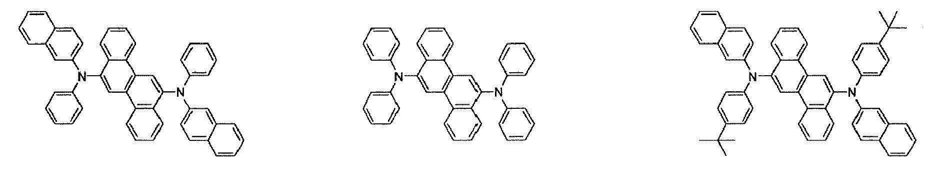

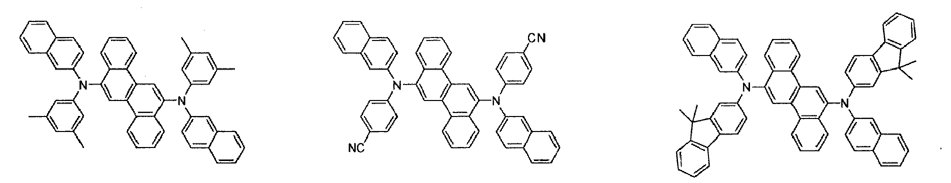

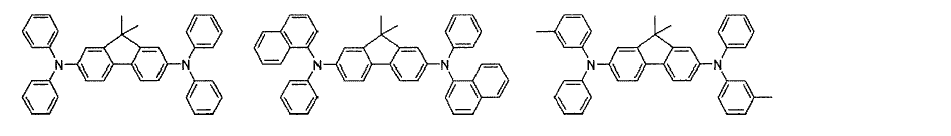

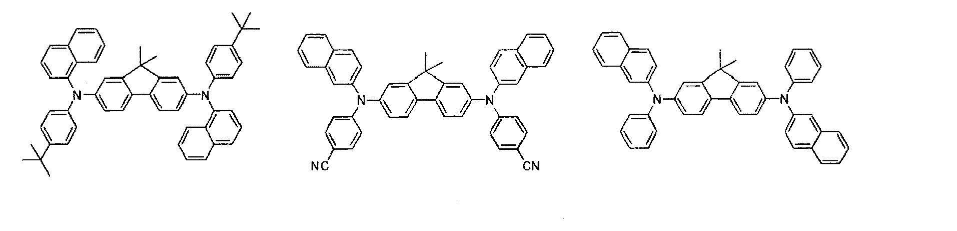

In an organic electroluminescent device according to the present invention, it is preferable to arrange one or more layer(s) (here-in-below, referred to as the "surface layer") selected from chalcogenide layers, metal halide layers and metal oxide layers, on the inner surface of at least one side of the pair of electrodes. Specifically, it is preferable to arrange a chalcogenide layer of silicon and aluminum metal (including oxides) on the anode surface of the EL medium layer, and a metal halide layer or a metal oxide layer on the cathode surface of the EL medium layer. As the result, stability in operation can be obtained.

Examples of chalcogenides preferably include SiOₓ (1≤X≤2), AlOₓ (1≤X≤1.5), SiON, SiAlON, or the like. Examples of metal halides preferably include LiF, MgF₂, CaF₂, fluorides of rare earth metal or the like. Examples of metal oxides preferably include Cs₂O, Li₂O, MgO, SrO, BaO, CaO, or the like.

In an electroluminescent device according to the present invention, it is also preferable to arrange, on at least one surface of the pair of electrodes thus manufactured, a mixed region of electron transport compound and a reductive dopant, or a mixed region of a hole transport compound with an oxidative dopant. Accordingly, the electron transport compound is reduced to an anion, so that injection and transportation of electrons from the mixed region to an EL medium are facilitated. In addition, since the hole transport compound is oxidized to form a cation, injection and transportation of holes from the mixed region to an EL medium are facilitated. Preferable oxidative dopants include various Lewis acids and acceptor compounds. Preferable reductive dopants include alkali metals, alkali metal compounds, alkaline earth metals, rare-earth metals, and mixtures thereof.

The organic electroluminescent compounds according to the present invention, having high luminous efficiency and excellent life property of material, are advantageous in that they can be employed to manufacture organic light emitting diodes (OLED's) having excellent operation life.

### Best Mode

The present invention is further described by referring to representative compounds with regard to the organic electroluminescent compounds according to the invention, preparation thereof and luminous properties of the devices manufactured therefrom, but those examples are provided for illustration of the embodiments only, not being intended to limit the scope of the invention by any means.

### Preparation Examples

### [Preparation Example 1] Preparation of Compound (1)

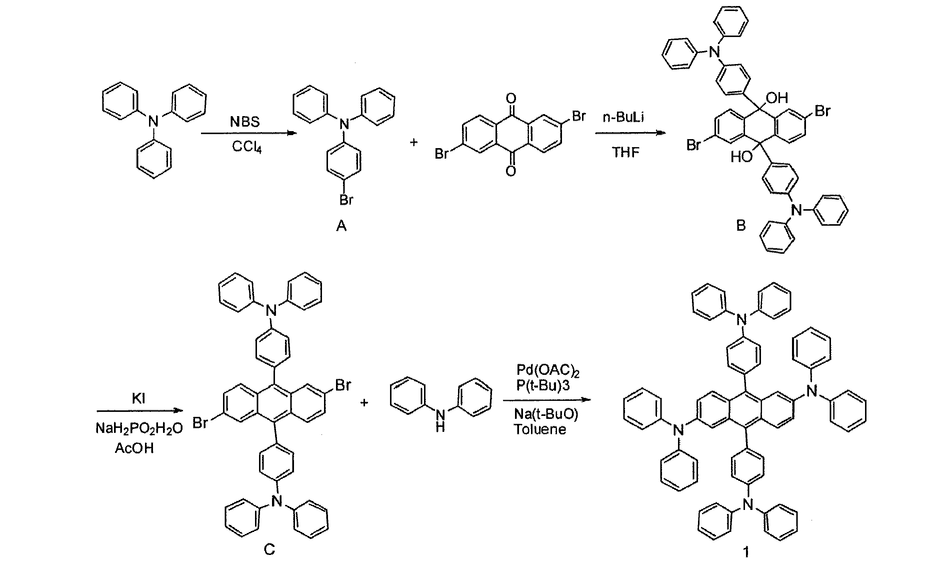

### Preparation of Compound (A)

A one-liter flask was charged with triphenylamine (40 g, 0.163 mol) and NBS (N-bromosuccinimide) (29 g, 0.163 mol). After adding tetrachloride (820 mL) thereto under nitrogen atmosphere, the mixture was stirred at 70°C for 4 hours. When the reaction was completed, remaining succinimide solid was filtered off. The filtrate was evaporated by using a rotary evaporator, and the solid produced was washed twice with ethanol to obtain white solid compound (A) (24.8 g, 0.077 mol).

### Preparation of Compound (B)

Compound (A) (24.8 g, 0.077 mol) was dissolved in THF (140 mL), and n-BuLi (2.5 M in hexane) (33 mL, 0.082 mol) was added thereto at -78°C. After stirring for 1 hour, 2,6-dibromoanthraquinone (7 g, 0.019 mol) was added to the mixture, and stirred for 12 hours. When the reaction was completed, the reaction mixture was washed three times with ethyl acetate and distilled water, and evaporated by using a rotary evaporator. The solid produced was then washed twice with methanol to obtain Compound (B) (7.7 g, 0.009 mol) as purple solid.

### Preparation of Compound (C)

A reaction vessel was charged with Compound (B) (7.7 g, 0.009 mol), potassium iodide (6 g, 0.036 mol), sodiumphosphinate monohydrate (NaPH₂O₂· H₂O) (7.6 g, 0.072 mol) and acetic acid (50 mL), and the mixture was stirred under reflux for 12 hours. When the reaction was completed, sodium hydroxide solution was added to neutralize the reaction mixture. Wasing several times with methanol and hexane gave Compound (C) (4 g, 0.005 mol) as yellow solid.

### Preparation of Compound (1)

A reaction vessel was charged with Compound (C) (4 g, 0.005 mol), diphenylamine (3.3 g, 0.019 mol), sodium-tert-butoxide (1.5 g, 0.016 mol) and toluene (35 mL). While stirring the mixture under reflux up to 70°C, palladium acetate (0.1 g, 0.0005 mol) and tert-butylphosphine (in 50% toluene) (0.4 mL, 0.0009 mol) were added thereto, and the resultant mixture was stirred under reflux up to 120°C for 12 hours. When the reaction was completed, the product was recrystallized from methanol, ethylacetate and tetrahydrofuran to obtain Compound (1) (2 g, 0.002 mmol) as dark yellow solid.

According to the same procedure as in Preparation Example 1, prepared were the organic electroluminescent compounds (Compounds 1 to 93), of which the ¹H NMR and MS/FAB data are listed in Table 1.

**Table 1**

| **Compound** | ¹H NMR(CDCl₃,200 MHz) | MS/FAB | |
|---|---|---|---|
| | | found | calculated |
| **1** | δ = 6.63(16H,m), 6.69(4H,m). 6.81(8H,m), 6.83(2H,m), 7.03(2H,m), 7.2(16H,m), 7.54(4H,m), 7.75(2H,m) | 999.3 | 998.4 |
| **2** | δ = 6.63(8H,m), 6.69(4H,m), 6.81(4H,m), 6.83(2H,m), 7.03(2H,m), 7.2(8H.m), 7.36(4H,m), 7.49(4H,m), 7.5(4H,m), 7.54(4H,m), 7.74(4H,m), 7.75(2H,m), 7.77(4H,m), 7.84(4H,m), 7.88(4H,m) | 1199.5 | 1198.5 |
| **3** | δ = 6.63(8H,m), 6.69(4H,m), 6.81(4H,m), 6.83(2H,m), 6.98(4H,m), 7.03(2H,m), 7.2(8H,m), 7.38(4H,m), 7.53(4H,m), 7.54(8H,m), 7.57(4H,m), 7.75(2H,m), 8.02(4H,m), 8.07(4H,m) | 1199.5 | 1198.5 |
| **4** | δ =6.63(8H,m), 6.69(12H,m), 6.81(4H,m), 6.83(2H.m). 7.03(2H,m), 7.2(8H,m), 7.41(4H,m), 7.51(8H,m), 7.52(8H,m), 7.54(12H,m), 7.75(2H,m) | 1303.6 | 1302.6 |
| **5** | δ = 1.72(24H.s), 6.58(4H,m), 6.63(8H,m), 6.69(4H,m), 6.75(4H.m). 6.81(4H,m), 6.83(2H,m), 7.03(2H,m), 7.2(8H,m), 7.28(4H,m), 7.38(4H,m), 7.54(4H,m), 7.55(4H,m), 7.62(4H,m), 7.75(2H,m), 7.87(4H,m) | 1463.9 | 1462.7 |
| **6** | δ = 6.63(8H,m), 6.69(4H,m), 6.81 (4H,m), 7.2(8H,m), 7.25(2H,m), 7.29(2H,m), 7.33(2H,m), 7.4(2H,m), 7.5(2H,m), 7.54(4H,m), 7.63(2H,m), 7.9(4H,m), 7.94(2H,m), 8.12(2H,m), 8.55(2H,m) | 995.2 | 994.4 |
| **8** | δ = 2.34(12H,s), 6.51(8H,m), 6.63(8H,m), 6.69(4H,m), 6.81(4H,m). 6.83(2H,m), 6.98(8H,m). 7.03(2H,m), 7.2(8H,m), 7.54(4H,m), 7.75(2H,m) | 1055.4 | 1054.5 |
| **9** | δ = 1.35(36H,s), 6.55(8H,m), 6.63(8H,m), 6.69(4H,m), 6.81(4H,m), 6.83(2H,m), 7.01(8H,m), 7.03(2H,m), 7.2(8H,m), 7.54(4H,m), 7.75(2H,m) | 1223.7 | 1222.7 |
| **12** | δ = 2.34(24H,s), 6.36(8H,m), 6.63(8H,m), 6.69(4H,m), 6.71(4H,m), 6.81(4H,m), 6.83(2H,m), 7.03(2H,m), 7.2(8H,m), 7.54(4H,m), 7.75(2H,m) | 1111.5 | 1110.6 |
| **13** | δ = 6.62(4H,m), 6.63(8H,m), 6.69(4H,m), 6.7(4H,m), 6.81(4H,m), 6.83(2H,m), 7.03(2H,m), 7.2(8H,m), 7.54(4H,m), 7.55(4H,m), 7.75(2H,m), 8.07(4H,m) | 1003.2 | 1002.4 |
| **16** | δ = 2.88(8H,s), 6.58(4H,m), 6.63(8H,m), 6.69(4H,m), 6.76(4H,m), 6.81(4H,m), 6.83(2H,m), 7.02(4H,m), 7.03(2H,m), 7.04(4H,m), 7.2(8H,m), 7.54(4H,m), 7.75(2H,m) | 1051.3 | 1050.5 |
| **22** | δ = 2.34(6H,s), 6.51(4H,m), 6.61(4H,m), 6.63(8H,m), 6.69(4H,m), 6.81(4H,m), 6.83(2H,m), 6.98(4H,m), 6.99(4H,m), 7.03(2H,m), 7.2(8H,m), 7.54(4H,m), 7.75(2H,m) | 1063.3 | 1062.5 |
| **26** | δ = 6.63(12H,m), 6.69(4H,m), 6.81(6H,m), 6.83(4H,m), 7.03(4H,m), 7.2(12H,m), 7.39(4H,m), 7.54(4H,m), 7.75(4H,m), 7.91(4H,m), 8.08(2H,m), 8.19(2H,m) | 1199.5 | 1198.5 |
| **29** | δ = 6.63(8H,m), 6.69(4H,m), 6.81(4H,m), 6.83(2H,m), 6.98(4H,m), 7.03(2H,m), 7.2(8H,m), 7.38(4H,m), 7.53(4H,m), 7.54(BH,m), 7.57(4H,m), 7.75(2H,m), 8.02(4H,m), 8.07(4H,m) | 1199.5 | 1198.5 |
| **33** | δ = 1.35(36H,s), 6.55(8H,m), 6.63(8H,m), 6.69(4H,m), 6.81(4H,m), 6.83(2H,m), 7.01(8H,m), 7.03(2H,m), 7.2(8H,m), 7.54(4H,m), 7.75(2H,m) | 1223.7 | 1222.7 |
| **36** | δ = 2.34(24H,s), 6.44(4H,m), 6.51(BH,m), 6.55(4H,m), 6.59(4H,m), 6.69(4H,m), 6.83(2H,m), 6.98(8H,m), 7.03(2H,m), 7.08(4H,m), 7.54(4H,m), 7.75(2H,m) | 1111.5 | 1110.6 |
| **38** | δ = 6.69(4H,m), 6.81(16H,m), 6.83(2H,m), 7.03(2H,m), 7.39(16H,m), 7.54(4H,m), 7.75(2H,m) | 1199.3 | 1198.4 |
| **41** | δ = 6.62(8H,m), 6.69(4H,m), 6.7(8H,m), 6.83(2H,m), 7.03(2H,m), 7.54(4H,m), 7.55(8H,m), 7.75(2H,m), 8.07(8H,m) | 1007.2 | 1006.4 |
| **56** | δ = 6.63(12H,m), 6.69(8H,m), 6.81(6H,m), 6.83(2H,m), 7.03(2H,m), 7.2(12H,m), 7.41(2H,m), 7.51(4H,m), 7.52(4H,m), 7.54(8H,m), 7.75(2H,m) | 1151.4 | 1150.5 |
| **57** | δ = 1.72(12H,s), 6.63(12H,m), 6.69(8H,m), 6.81(6H,m), 6.83(2H,m), 7.03(2H,m), 7.2(12H,m), 7.28(2H,m), 7.38(2H,m), 7.54(8H,m), 7.55(2H,m), 7.63(2H,m), 7.75(2H,m), 7.77(2H,m), 7.87(2H,m), 7.93(2H,m) | 1383.8 | 1382.6 |
| **61** | δ = 1.72(12H,s), 6.63(8H,m), 6.69(8H,m), 6.81(4H,m), 6.83(2H,m), 6.98(2H,m), 7.03(2H,m), 7.2(8H,m), 7.28(2H,m), 7.38(4H,m), 7.53(2H,m), 7.54(10H,m), 7.55(2H,m), 7.57(2H,m), 7.63(2H,m), 7.75(2H,m), 7.77(2H,m), 7.87(2H,m), 7.93(2H,m), 8.02(2H,m), 8.07(2H,m) | 1483.9 | 1482.7 |
| **63** | δ = 1.72(12H,s), 6.63(4H,m), 6.69(8H,m), 6.81(2H,m), 6.83(2H,m), 7.03(2H,m), 7.2(4H,m), 7.28(2H,m), 7.36(4H,m), 7.38(2H,m), 7.49(4H,m), 7.5(4H,m), 7.54(8H,m), 7.55(2H,m), 7.63(2H,m), 7.74(4H,m), 7.75(2H,m), 7.77(6H,m), 7.84(4H,m), 7.87(2H,m), 7.88(4H,m), 7.93(2H,m) | 1584.0 | 1582.7 |
| **71** | δ = 1.35(72H,s), 6.55(16H,m), 6.69(4H,m), 6.83(2H,m), 7.01(16H,m), 7.03(2H,m), 7.54(4H,m), 7.75(2H,m) | 1448.1 | 1446.9 |
| **72** | δ = 6.63(16H,m), 6.69(4H,m), 6.81(8H,m), 6.83(2H,m), 7.03(2H,m), 7.2(16H,m), 7.54(4H,m), 7.75(2H,m) | 999.3 | 998.4 |
| **75** | δ = 2.34(24H,s), 6.51(16H,m), 6.69(4H,m), 6.83(2H.m). 6.98(16H,m), 7.03(2H,m), 7.54(4H,m), 7.75(2H,m) | 1111.5 | 1110.6 |
| **76** | δ = 6.62(2H,m), 6.63(16H,m), 6.69(4H,m), 6.81(8H,m), 7.2(16H,m), 7.22(2H,m), 7.4(2H,m), 7.54(4H,m) | 999.3 | 998.4 |
| **77** | δ = 6.45(2H,m), 6.63(16H,m), 6.69(4H,m), 6.81(BH,m), 7.2(16H,m), 7.39(2H,m), 7.54(4H,m), 7.91(2H,m) | 999.3 | 998.4 |
| **78** | δ = 6.63(16H,m), 6.69(4H,m), 6.81(8H,m), 7.2(16H,m), 7.54(4H,m), 7.59(2H,m), 7.93(2H,m), 8.09(2H,m) | 999.3 | 998.4 |
| **81** | δ = 2.34(12H,s), 6.51(8H,m), 6.63(8H,m), 6.69(4H.m). 6.81(4H,m), 6.98(8H,m), 7.2(8H,m), 7.54(4H,m), 7.59(2H,m), 7.93(2H,m), 8.09(2H,m) | 1055.4 | 1054.5 |
| **82** | δ = 1.35(36H,s), 6.55(8H,m), 6.63(8H,m), 6.69(4H,m), 6.81(4H,m), 7.01(8H,m), 7.2(8H,m), 7.54(4H,m), 7.59(2H,m), 7.93(2H,m). 8.09(2H,m) | 1223.7 | 1222.7 |
| **83** | δ = 6.63(16H,m), 6.69(4H,m), 6.81(8H,m), 7.2(16H,m), 7.54(4H,m), 7.59(2H,m), 7.93(2H,m), 8.09(2H,m) | 999.3 | 998.4 |
| **85** | δ = 6.63(16H,m), 6.69(4H,m), 6.81(8H,m), 7.2(16H,m), 7.43(2H,m). 7.54(4H,m), 7.59(2H,m), 7.83(2H,m) | 999.3 | 998.4 |
| **86** | δ = 6.63(16H,m), 6.69(4H,m), 6.81(8H,m), 7.2(16H,m), 7.36(2H,m), 7.54(4H,m), 7.67(2H,m), 7.84(2H,m) | 999.3 | 998.4 |
| **87** | δ = 6.63(8H,m), 6.69(4H,m), 6.81(4H,m), 7.2(8H,m), 7.36(6H,m), 7.49(4H,m), 7.5(4H,m), 7.54(4H,m), 7.67(2H,m), 7.74(4H,m), 7.77(4H,m), 7.84(6H.m), 7.88(4H,m) | 1199.5 | 1198.5 |

### [Example 1] Manufacture of OLED's by using the organic electroluminescent compounds of the invention

An OLED device was manufactured by using the electroluminescent compound according to the invention.

First, a transparent electrode ITO thin film (15 Ω/□) (2) prepared from glass for OLED (1) (manufactured by Samsung-Corning) was subjected to ultrasonic washing with trichloroethylene, acetone, ethanol and distilled water, sequentially, and stored in isopropanol before use.

Then, an ITO substrate was equipped in a substrate folder of a vacuum vapor-deposit device, and 4,4',4"-tris(N,N-(2-naphthyl)-phenylamino)triphenylamine (2-TNATA) (of which the structure is shown below) was placed in a cell of the vacuum vapor-deposit device, which was then ventilated up to 10⁻⁶ torr of vacuum in the chamber. Electric current was applied to the cell to evaporate 2-TNATA, thereby providing vapor-deposit of a hole injecting layer (3) having 60 nm of thickness on the ITO substrate.

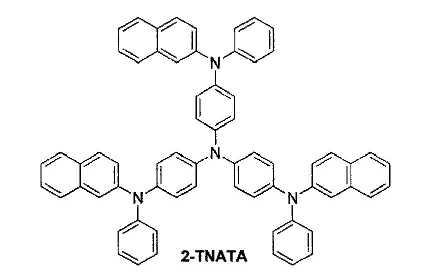

Then, to another cell of the vacuum vapor-deposit device, charged was N,N'-bis(α-naphthyl)-N,N'-diphenyl-4,4'-diamine (NPB) (of which the structure is shown below), and electric current was applied to the cell to evaporate NPB, thereby providing vapor-deposit of a hole transport layer (4) of 20 nm of thickness on the hole injecting layer.

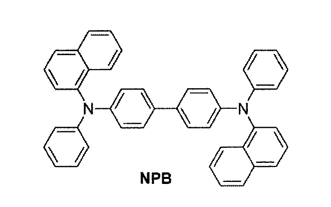

After forming the hole injecting layer and the hole transport layer, an electroluminescent layer was vapor-deposited as follows. To one cell of a vacuum vapor-deposit device, charged was H-28 (of which the structure is shown below) as a host, and a compound according to the invention (Compound 4) was charged to another cell as a dopant. Two substances were evaporated at different rates to give doping at 2 to 5% by weight on the basis of the host, to vapor-deposit an electroluminescent layer (5) with a thickness of 30 nm on the hole transport layer.

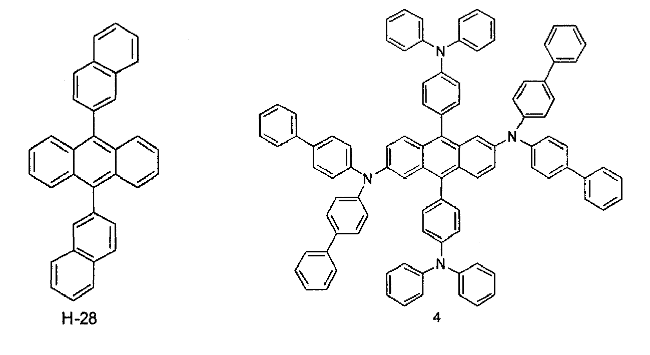

Then, tris(8-hydroxyquinoline)aluminum (III) (Alq) (of which the structure is shown below) was vapor-deposited as an electron transport layer (6) with a thickness of 20 nm, and lithium quinolate (Liq) (of which the structure shown below) was vapor-deposited as an electron injecting layer (7) with a thickness of 1 to 2 nm. Thereafter, an Al cathode (8) was vapor-deposited with a thickness of 150 nm by using another vacuum vapor-deposit device to manufacture an OLED.

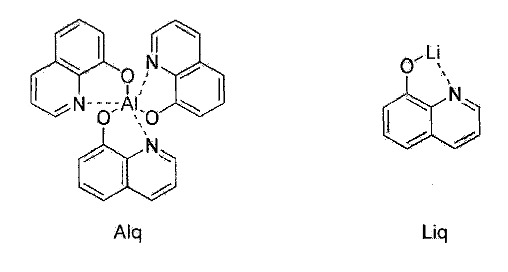

Each material employed for manufacturing an OLED was used as the electroluminescent material after purifying via vacuum sublimation at 10⁻⁶ torr.

### [Comparative Example 1] Manufacture of an OLED by using conventional electroluminescent material

After forming a hole injecting layer and hole transport layer according to the same procedure as described in Example 1, tris(8-hydroxyquinoline)-aluminum (III) (Alq) was charged to another cell of said vacuum vapor-deposit device as an electroluminescent host material, while Coumarin 545T (C545T) was charged to still another cell. The two materials were evaporated at different rates to carry out doping, thereby vapor-depositing an electroluminescent layer with a thickness of 30 nm on the hole transport layer. The doping concentration preferably is from 1 to 3% by weight on the basis of Alq.

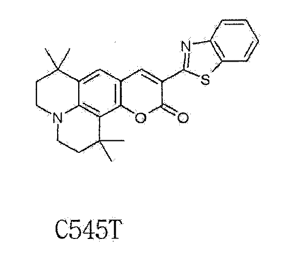

Then, an electron transport layer and an electron injecting layer were vapor-deposited according to the same procedure as in Example 1, and Al cathode was vapor-deposited by using another vacuum vapor-deposit device with a thickness of 150 nm, to manufacture an OLED.

### [Comparative Example 2] Manufacture of an OLED by using conventional electroluminescent material

After forming a hole injecting layer and a hole transport layer according to the same procedure as described in Example 1, dinaphthylanthracene (DNA) was charged to another cell of said vacuum vapor-deposit device as an electroluminescent host material, while Compound (G) was charged to still another cell. The two materials were evaporated at different rates to carry out doping at a concentration of 2 to 5% by weight on the basis of the host, thereby vapor-depositing an electroluminescent layer with a thickness of 30 nm on the hole transport layer.

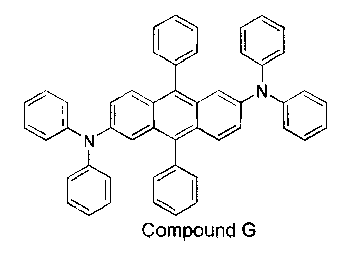

Then, an electron transport layer and an electron injecting layer were vapor-deposited according to the same procedure as in Example 1, and Al cathode was vapor-deposited by using another vacuum vapor-deposit device with a thickness of 150 nm, to manufacture an OLED.

### [Example 2] Electroluminescent properties of OLED's manufactured

The luminous efficiency of the OLED's comprising the organic electroluminescent compound according to the present invention (Examples 1) or conventional EL compounds (Comparative Examples 1 and 2) were measured at 5,000 cd/m² and 20,000 cd/m², respectively, and the results are shown in Table 2. Since the electroluminescent properties in high luminance region are very important, particularly in case of green electroluminescent materials, the data at high luminance (about 20,000 cd/m²) are attached in order to reflect the properties.

**Table 2**

| No. | Host | Dopant | Doping Conc. (wt%) | Efficiency(cd/A) | | Color |
|---|---|---|---|---|---|---|
| | | | | @5,000 cd/m² | @20,000 cd/m² | |
| 1 | H-28 | 4 | 3.0 | 21.2 | 20.4 | Green |
| 2 | H-4 | 5 | 3.0 | 19.5 | 18.6 | Green |
| 3 | H-5 | 30 | 3.0 | 19.7 | 19.0 | Green |
| 4 | H-10 | 31 | 3.0 | 18.7 | 18.0 | Green |
| 5 | H-11 | 39 | 3.0 | 18.6 | 18.0 | Green |
| 6 | H-23 | 56 | 3.0 | 19.4 | 18.7 | Green |
| 7 | H-44 | 76 | 3.0 | 18.2 | 17.5 | Green |
| 8 | H-56 | 78 | 3.0 | 18.6 | 17.9 | Green |
| Comp. 1 | Alq | Compound C545T | 1.0 | 10.3 | 9.1 | Green |
| Comp. 2 | H-28 | Compound G | 3.0 | 16.0 | 13.5 | Green |

As can be seen from Table 2, it is found that Compound H-28 and Compound (4) with 3.0wt% of doping exhibited highest luminous efficiency, which is more than twice of that of conventional Alq:C545T (Comparative Example 1), being corresponding to 20∼30% increase of luminous efficiency as compared to Compound (G) (Comparative Example 2).

The high performance electroluminescent materials according to the invention showing the decrease of the efficiency within 1 ∼ 2 cd/A at high luminance of about 20,000 cd/m², suggests that they have excellent material properties to maintain good feature even at high luminance. Thus the materials can exhibit advantageous properties for both passive and active organic electroluminescent devices. Since the materials according to the invention comprise four (4) arylamine groups as auxochromes, they show excellent color purity with narrow electroluminescence range as well as high luminescent properties.

## Claims

1. An organic electroluminescent compound represented by Chemical Formula (1): 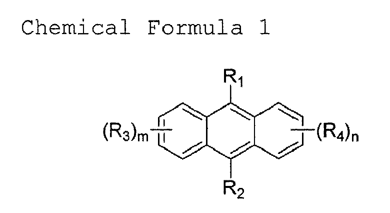 wherein,
R₁, R₂, R₃ and R₄ are independently selected from the following structures: 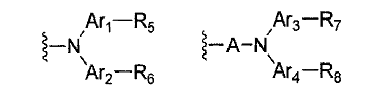
A represents (C6-C60)arylene or (C5-C60)heteroarylene, and the arylene or heteroarylene of A may be further substituted by one or more substituent(s) selected from halogen, deuterium, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl;
Ar₁, Ar₂, Ar₃ and Ar₄ independently represent (C6-C60)arylene or (C4-C60)heteroarylene, which may be further substituted by one or more substituent(s) selected from deuterium, halogen, (C1-C60)alkyl, halo(C1-C60)alkyl, 5- or 6-membered heterocycloalkyl containing one or more heteroatom(s) selected from N, O and S, (C3-C60)cycloalkyl, (C6-C60)aryl, (C4-C60)heteroaryl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl;
R₅, R₆, R₇ and R₈ independently represent hydrogen, deuterium, halogen, (C1-C60)alkyl, halo(C1-C60)alkyl, 5- or 6-membered heterocycloalkyl containing one or more heteroatom(s) selected from N, O and S, (C3-C60)cycloalkyl, (C6-C60)aryl, (C4-C60)heteroaryl, tri(C1-C60)alkylsily di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl; or R₅ and R₆, or R₇ and R₈ may be linked via (C3-C60)alkylene or (C3-C60)alkenylene with or without (C1-C10)alkyl susbsituent to form a fused ring, and carbon atom of the alkylene may be further substituted by one or more substituent(s) selected from NR₁₁, SiR₁₂R₁₃, O and S;
R₁₁ through R₁₃ independently represent hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl; or R₁₂ and R₁₃ may be linked via (C3-C60)alkylene or (C3-C60)alkenylene with or without a fused ring to form a spiro ring or a fused ring; and
m and n independently represent an integer from 0 to 4, provided that m+n is an integer from 1 to 8.

2. The organic electroluminescent compound according to claim 1, which is represented by one of Chemical Formulas (2) to (9): 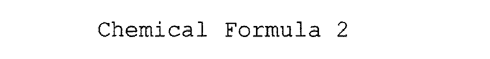 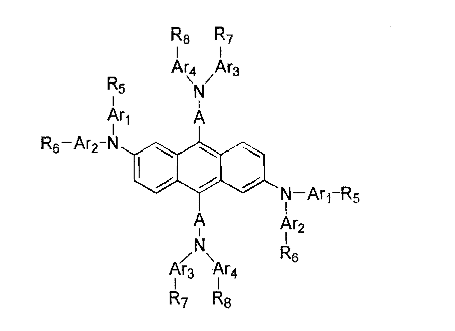 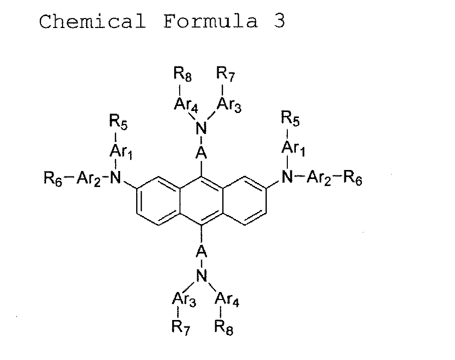 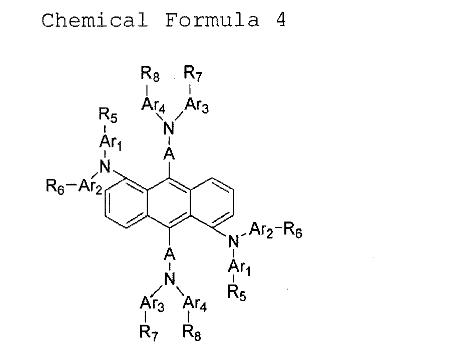 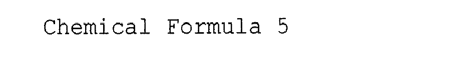 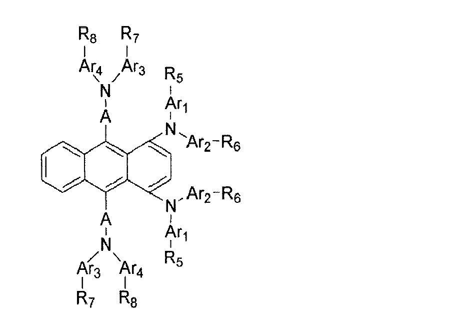 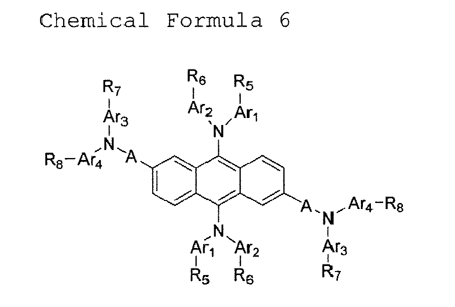 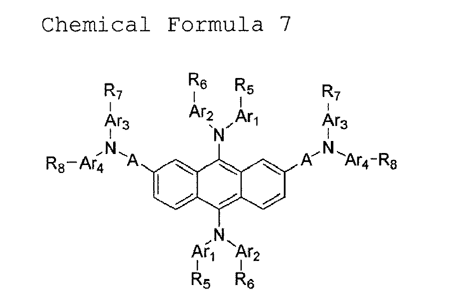 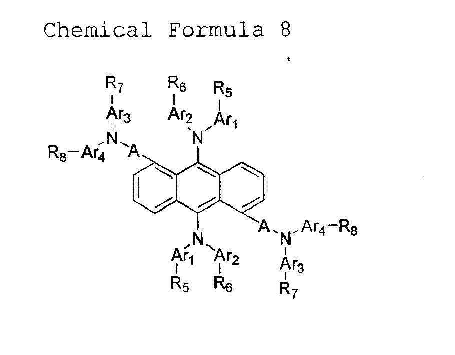 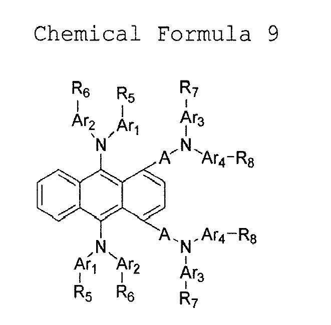 wherein, A, Ar₁, Ar₂, Ar₃, Ar₄, R₅, R₆, R₇ and R₈ are defined as in Chemical Formula (1) of claim 1.

3. The organic electroluminescent compound according to claim 2, groups 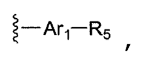 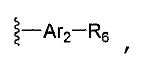 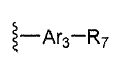 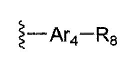 are independently selected from the following structures: 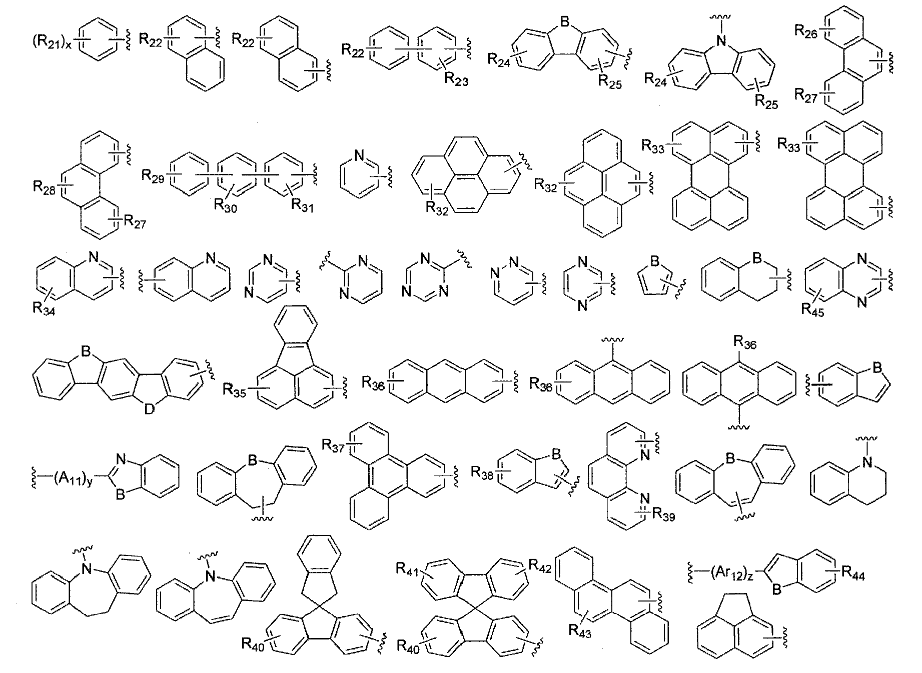 wherein, R₂₁ represents (C1-C60)alkyl, (C1-C30)alkoxy, cyano, halogen, (C6-C60)aryl, (C5-C60)heteroaryl, mono or di(C1-C30)alkylamino, mono or di(C6-C60)arylamino, tri(C1-C30)alkylsilyl, di(C1-C30)alkyl(C6-C30)arylsilyl or tri(C6-C30)arylsilyl;
R₂₂ through R₄₅ independently represent hydrogen, deuterium, (C1-C60)alkyl, (C1-C30)alkoxy, cyano, halogen, (C6-C60)aryl, (C5-C60)heteroaryl, tri(C1-C30)alkylsilyl, di(C1-C30)alkyl(C6-C30)arylsilyl or tri(C6-C30)arylsilyl;
the alkyl, alkoxy, aryl and heteroaryl of R₂₁ through R₄₅ may be further substituted by one or more substituent(s) selected from deuterium, (C1-C60)alkyl, (C1-C30)alkoxy, halogen, cyano, tri(C1-C30)alkylsilyl, di(C1-C30)alkyl(C6-C30)arylsilyl, tri(C6-C30)arylsilyl, (C5-C60)heteroaryl and (C6-C60)aryl;
B and D independently represent CR₄₆R₄₇, NR₄₈, O or S;
R₄₆ through R₄₈ independently represent hydrogen, deuterium, (C1-C60)alkyl, (C1-C30)alkoxy, cyano, halo(C1-C60)alkyl, halogen, (C6-C60)aryl, tri(C1-C30)alkylsilyl, di(C1-C30)alkyl(C6-C30)arylsilyl or tri(C6-C30)arylsilyl;
the alkyl or aryl of R₄₆ through R₄₈ may be further substituted by one or more substituent(s) selected from deuterium, (C1-C60)alkyl, (C1-C30)alkoxy, halogen, cyano, tri(C1-C30)alkylsilyl, di(C1-C30)alkyl(C6-C30)arylsilyl, (C5-C60)heteroaryl and (C6-C60)aryl;
Ar₁₁ and Ar₁₂ independently represent (C6-C60)arylene or (C5-C60)heteroarylene; and the arylene or heteroarylene of Ar₁₁ and Ar₁₂ may be further substituted by one or more substituent(s) selected from deuterium, (C1-C60)alkyl, (C1-C30)alkoxy, halogen, cyano, tri(C1-C30)alkylsilyl, di(C1-C30)alkyl(C6-C30)arylsilyl, tri(C6-C30)arylsilyl, (C5-C60)heteroaryl and (C6-C60)aryl;
x represents an integer from 0 to 5; and
y and z represent an integer from 0 to 2.

4. The organic electroluminescent compound according to claim 2, wherein A is selected from the following structures: 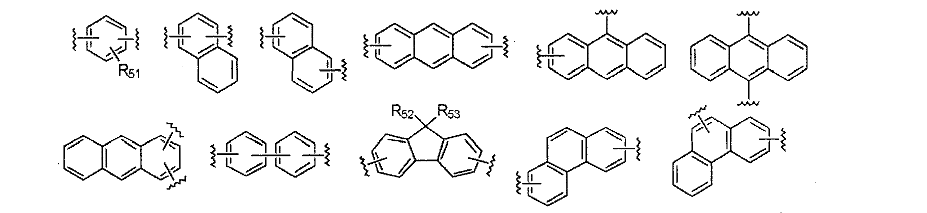 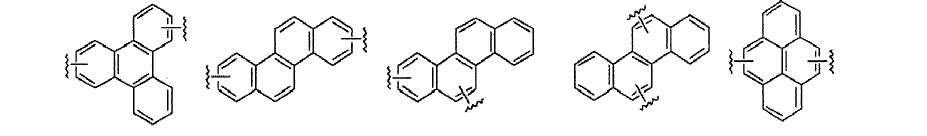 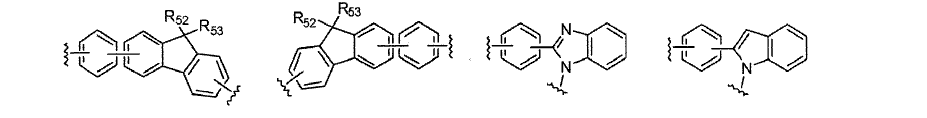 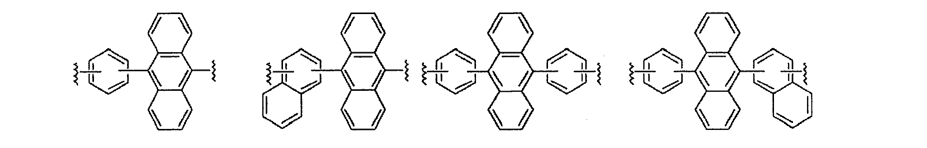 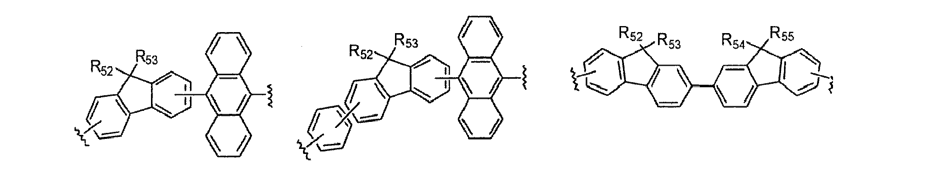 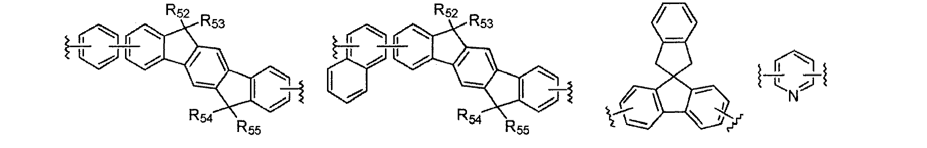 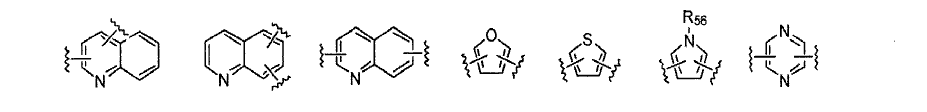 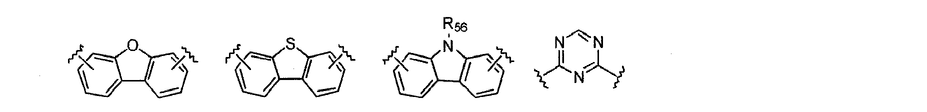 wherein, R₅₁ represents deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl;
R₅₂ through R₅₆ independently represent deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl, or each of R₅₂ through R₅₆ may be linked to an adjacent substituent via (C3-C60)alkylene or (C3-C60)alkenylene with or without a fused ring to form an alicyclic ring, or a monocyclic or polycyclic aromatic ring.

5. An organic electroluminescent device which is comprised of a first electrode; a second electrode; and at least one organic layer(s) interposed between the first electrode and the second electrode; wherein the organic layer comprises an electroluminescent layer comprising an organic electroluminescent compound represented by Chemical Formula (1): 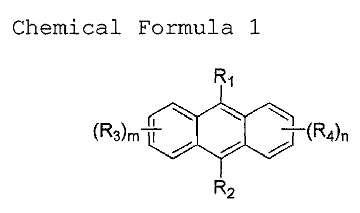 wherein,
R₁, R₂, R₃ and R₄ are independently selected from the following structures: 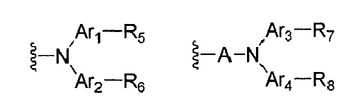
A represents (C6-C60)arylene or (C5-C60)heteroarylene, and the arylene or heteroarylene of A may be further substituted by one or more substituent(s) selected from halogen, deuterium, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl;
Ar₁, Ar₂, Ar₃ and Ar₄ independently represent (C6-C60)arylene or (C4-C60)heteroarylene, which may be further substituted by one or more substituent(s) selected from deuterium, halogen, (C1-C60)alkyl, halo(C1-C60)alkyl, 5- or 6-membered heterocycloalkyl containing one or more heteroatom(s) selected from N, O and S, (C3-C60)cycloalkyl, (C6-C60)aryl, (C4-C60)heteroaryl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl;
R₅, R₆, R₇ and R₈ independently represent hydrogen, deuterium, halogen, (C1-C60)alkyl, halo(C1-C60)alkyl, 5- or 6-membered heterocycloalkyl containing one or more heteroatom(s) selected from N, O and S, (C3-C60)cycloalkyl, (C6-C60)aryl, (C4-C60)heteroaryl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl; or R₅ and R₆, or R₇ and R₈ may be linked via (C3-C60)alkylene or (C3-C60)alkenylene with or without (C1-C10)alkyl susbsituent to form a fused ring, and carbon atom of the alkylene may be further substituted by one or more substituent(s) selected from NR₁₁, SiR₁₂R₁₃, O and S;
R₁₁ through R₁₃ independently represent hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl; or R₁₂ and R₁₃ may be linked via (C3-C60)alkylene or (C3-C60)alkenylene with or without a fused ring to form a spiro ring or a fused ring; and
m and n independently represent an integer from 0 to 4, provided that m+n is an integer from 1 to 8 and one or more host(s) selected from the compounds represented by Chemical Formula (12) or (14): 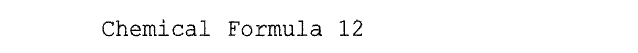 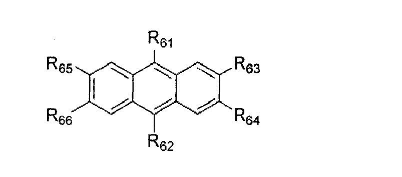 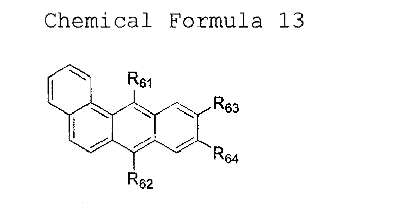 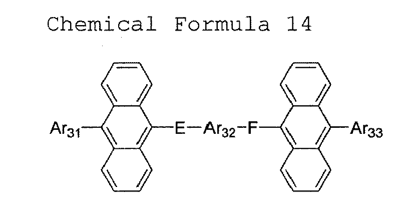 In Chemical Formulas (12) to (14),
R₆₁ and R₆₂ independently represent (C6-C60)aryl, (C4-C60)heteroaryl, a 5- or 6-membered heterocycloalkyl containing one or more heteroatom(s) selected from N, O and S, or (C3-C60)cycloalkyl; and the aryl or heteroaryl of R₆₁ and R₆₂ may be further substituted by one or more substituent(s) selected from a group consisting of deuterium, (C1-C60)alkyl, halo(C1-C60)alkyl, (C1-C60)alkoxy, (C3-C60)cycloalkyl, (C6-C60)aryl, (C4-C60)heteroaryl, halogen, cyano, tri(C1-C60)alkylsilyl, di(C1-C60)alkyl(C6-C60)arylsilyl and tri(C6-C60)arylsilyl;
R₆₃ through R₆₆ represent hydrogen, deuterium, (C1-C60)alkyl, (C1-C60)alkoxy, halogen, (C4-C60)heteroaryl, (C5-C60)cycloalkyl or (C6-C60)aryl; and the heteroaryl, cycloalkyl or aryl of R₆₃ through R₆₆ may be further substituted by one or more substituent(s) selected from a group consisting of (C1-C60)alkyl with or without halogen substituent(s), deuterium, (C1-C60)alkoxy, (C3-C60)cycloalkyl, halogen, cyano, tri(C1-C60)alkylsilyl, di(C1-C60)alkyl(C6-C60)arylsilyl and tri(C6-C60)arylsilyl;
E and F independently represent a chemical bond, or (C6-C60)arylene with or without one or more substituent(s) selected from deuterium, (C1-C60)alkyl, (C1-C60)alkoxy, (C6-C60)aryl, (C4-C60)heteroaryl and halogen;
Ar₃₁ and Ar₃₃ represent aryl selected from the following structures, or (C4-C60)heteroaryl, and the aryl or heteroaryl of Ar₃₁ and Ar₃₃ may be substituted by one or more substituent(s) selected from (C1-C60)alkyl, (C1-C60)alkoxy, (C6-C60)aryl and (C4-C60)heteroaryl: 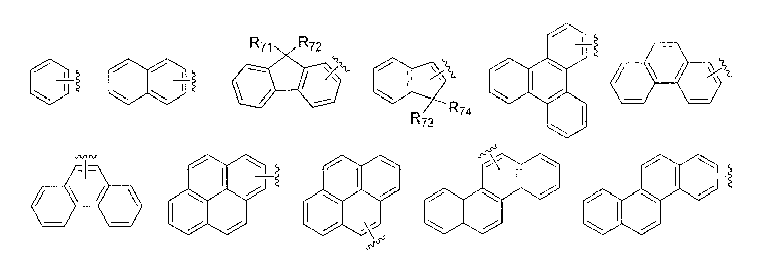
wherein, Ar₃₂ is selected from (C6-C60)arylene or (C4-C60)heteroarylene, preferably from phenylene, naphthylene, anthrylene, fluorenylene, phenanthrylene, tetracenylene, naphthacenylene, chrysenylene, pentacenylene, pyrenylene, heteroarylene and the compounds represented by the following structural formulas; and the arylene or heteroarylene of Ar₃₂ may be substituted by one or more substituent(s) selected from deuterium, (C1-C60)alkyl, (C1-C60)alkoxy, (C6-C60)aryl, (C4-C60)heteroaryl and halogen; 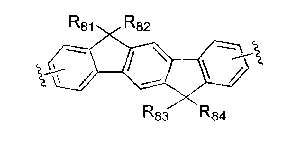
R₇₁ through R₇₄ independently represent hydrogen, deuterium, (C1-C60)alkyl or (C6-C60)aryl, or each of them may be linked to an adjacent substituent via (C3-C60)alkylene or (C3-C60)alkenylene with or without a fused ring to form an alicyclic ring, or a monocyclic or polycyclic aromatic ring;
R₈₁ through R₈₄ independently represent hydrogen, deuterium, (C1-C60)alkyl, (C1-C60)alkoxy, (C6-C60)aryl, (C4-C60)heteroaryl or halogen, or each of them may be linked to an adjacent substituent via (C3-C60)alkylene or (C3-C60)alkenylene with or without a fused ring to form an alicyclic ring, or a monocyclic or polycyclic aromatic ring.

6. The organic electroluminescent device according to claim 5, wherein the organic layer comprises one or more compound(s) selected from a group consisting of arylamine compounds and styrylarylamine compounds.

7. The organic electroluminescent device according to claim 5, wherein the organic layer comprises one or more metal(s) selected from a group consisting of organic metals of Group 1, Group 2, 4^{th} period and 5^{th} period transition metals, lanthanide metals and d-transition elements from the Periodic Table of Elements.

8. The organic electroluminescent device according to claim 5, wherein the organic layer comprises a charge generating layer as well as the electroluminescent layer.

9. A white organic electroluminescent device comprising an organic electroluminescent compound represented by Chemical Formula (1): 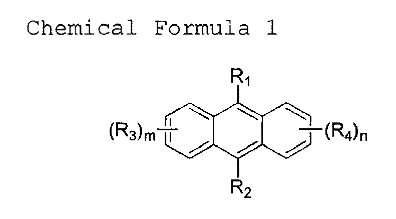 wherein,
R₁, R₂, R₃ and R₄ are independently selected from the following structures: 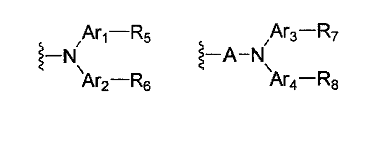
A represents (C6-C60)arylene or (C5-C60)heteroarylene, and the arylene or heteroarylene of A may be further substituted by one or more substituent(s) selected from halogen, deuterium, (C1-C60)alkyl, (C6-C60)aryl, (C4-C60) heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl;
Ar₁, Ar₂, Ar₃ and Ar₄ independently represent (C6-C60)arylene or (C4-C60)heteroarylene, which may be further substituted by one or more substituent(s) selected from deuterium, halogen, (C1-C60)alkyl, halo(Cl-C60)alkyl, 5- or 6-membered heterocycloalkyl containing one or more heteroatom(s) selected from N, O and S, (C3-C60)cycloalkyl, (C6-C60)aryl, (C4-C60)heteroaryl, tri(C1-C60)alkylsilyl, di(Cl-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl;
R₅, R₆, R₇ and R₈ independently represent hydrogen, deuterium, halogen, (C1-C60)alkyl, halo(C1-C60)alkyl, 5- or 6-membered heterocycloalkyl containing one or more heteroatom(s) selected from N, O and S, (C3-C60)cycloalkyl, (C6-C60)aryl, (C4-C60)heteroaryl, tri(C1-C60)alkylsilyl, di(C1-C60)alkyl(C6-C60) arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl; or R₅ and R₆, or R₇ and R₈ may be linked via (C3-C60)alkylene or (C3-C60)alkenylene with or without (C1-C10)alkyl susbsituent to form a fused ring, and carbon atom of the alkylene may be further substituted by one or more substituent(s) selected from NR₁₁, SiR₁₂R₁₃, O and S;
R₁₁ through R₁₃ independently represent hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl; or R₁₂ and R₁₃ may be linked via (C3-C60)alkylene or (C3-C60)alkenylene with or without a fused ring to form a spiro ring or a fused ring; and
m and n independently represent an integer from 0 to 4, provided that m+n is an integer from 1 to 8.
